# EUROPEAN PATENT SPECIFICATION

(11) **EP 4 325 555 B1**
(45) Date of publication and mention of the grant of the patent: **28.10.2026**
(21) Application number: 21941284.8
(22) Date of filing: 11.05.2021
(51) Int. Cl.: H10W 40/47, H10W 40/73, H10W 76/12

(54) **CHIP PACKAGE STRUCTURE**
CHIPGEHÄUSESTRUKTUR
STRUCTURE D'ENCAPSULATION DE PUCE

(43) Date of publication of application: 21.02.2024
(73) Proprietor: Huawei Technologies Co., Ltd., Longgang Shenzhen, Guangdong 518129 (CN)
(72) Inventor: LU, Jianbiao, Shenzhen, Guangdong 518129 (CN); CHEN, Jinyu, Shenzhen, Guangdong 518129 (CN); ZHENG, Jiantao, Shenzhen, Guangdong 518129 (CN); GU, Xinyuan, Shenzhen, Guangdong 518129 (CN)
(74) Representative: Goddar, Heinz J.
(86) International application number: PCT/CN2021/093127
(87) International publication number: WO 2022/236709

(56) References cited:
- CN-A- 110 094 985
- CN-A- 112 040 733
- CN-A- 112 701 087
- US-A1- 2008 000 087
- US-A1- 2009 140 417
- US-A1- 2019 385 931
- US-A1- 2020 100 396

## Description

### TECHNICAL FIELD

This application relates to the field of semiconductor heat dissipation technologies, and in particular, to a chip package structure including a chip heat dissipating lid.

### BACKGROUND

As a quantity of cores and speed of a chip increase, power consumption of the chip becomes higher. Therefore, a heat dissipation problem of the chip becomes one of bottlenecks that restrict chip development. Especially for a high-power chip with extremely high power consumption density, because hot spots are generated in a part of the chip, a heat dissipation problem of these hot spots has always been one of bottlenecks for improving power consumption performance of the chip. For example, when partial power density is 2-3 W/mm², a current common air cooling heat dissipation technology cannot support power consumption higher than 300 W. A bottleneck of a liquid cooling heat dissipation technology is 500 W. With a local hot spot with higher power consumption density, the power consumption bottleneck will be further reduced to 400 W.

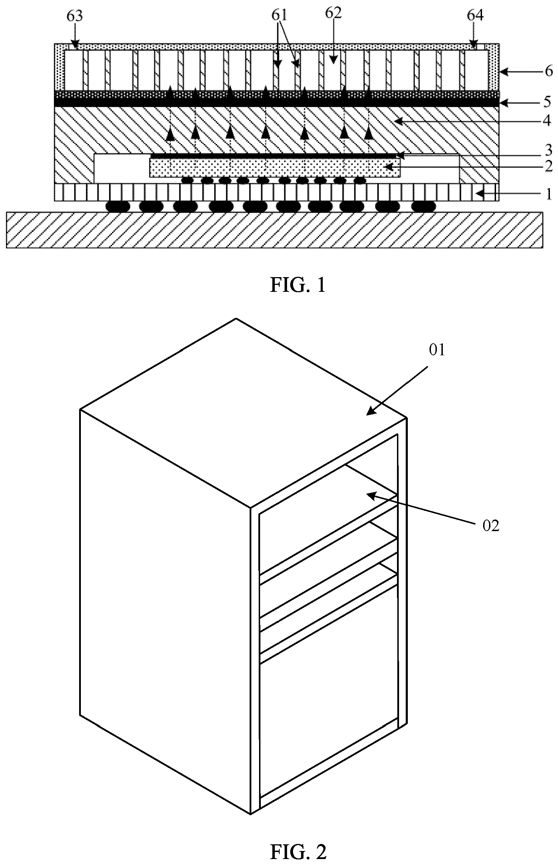

A chip component shown in FIG. 1 includes a cold plate 6 configured to dissipate heat for the chip. As shown in FIG. 1, a chip 2 is disposed on a package substrate 1, a cover plate 4 covers the chip 2, and the cold plate 6 covers the cover plate 4. In addition, a first thermal interface material (thermal interface material, TIM) layer 3 is provided at a position where the chip 2 and the cover plate 4 contact, and a second TIM layer 5 is provided at a position where the cold plate 6 and the cover plate 4 contact. A coolant flows into a water channel 62 through a liquid inlet port 63, and then flows out from a liquid outlet port 64. A plurality of fins 61 are disposed in the water channel 62 to improve heat exchange efficiency.

When the cold plate 6 shown in FIG. 1 is used to dissipate heat for the chip with high power consumption and high power density, it is difficult to eliminate a local hot spot of the chip, thereby restricting further development of the chip with high power consumption and high power density.

US 2020/100396 A1 discloses a cooling system, for example, for rack mounted electronic devices (e.g., servers, processors, memory, networking devices or otherwise) in a data center. In various disclosed implementations, the cooling system may be or include a liquid cold plate assembly that is part of or integrated with a server tray package. In some implementations, the liquid cold plate assembly includes a base portion and a top portion that, in combination, form a cooling liquid flow path through which a cooling liquid is circulated and a thermal interface between one or more heat generating devices and the cooling liquid.

US 2019/385931 A1 discloses an integrated circuit assembly that may be formed having a substrate, a first integrated circuit device electrically attached to the substrate, a second integrated circuit device electrically attached to the first integrated circuit device, and a heat dissipation device defining a fluid chamber, wherein at least a portion of the first integrated circuit device and at least a portion of the second integrated circuit device are exposed to the fluid chamber. In further embodiments, at least one channel may be formed in an underfill material between the first integrated circuit device and the second integrated circuit device, between the first integrated circuit device and the substrate, and/or between the second integrated circuit device and the substrate, wherein the at least one channel is open to the fluid chamber.

US 2009/140417 A1 discloses various semiconductor chip thermal management systems and methods. In one aspect, a method of manufacturing is provided that includes coupling a semiconductor chip to a substrate and coupling a diamond heat spreader that has a thermoelectric cooler to the semiconductor chip. A vapor chamber is coupled to the diamond heat spreader.

### SUMMARY

This application provides a chip package structure including a chip heat dissipating lid. A main objective is to provide a chip heat dissipating lid that can improve a heat dissipation effect, and in particular, can quickly eliminate a local hot spot of a chip with high power consumption and high power density.

To achieve the foregoing objective, the invention provides a chip package structure of claim 1. Further embodiments of this application are disclosed in the dependent claims and may use the following technical solutions.

According to a first aspect, this application provides a chip heat dissipating lid of claim 1. The chip heat dissipating lid is used in a chip package structure, and is configured to dissipate heat for a chip. The chip heat dissipating lid includes a bottom plate, and a cover plate that is engages the bottom plate. A fluid cavity is formed between the bottom plate and the cover plate that are engaging. The chip heat dissipating lid further includes at least one separator and at least one spoiler. The separator herein may also be referred to as a fin. The at least one separator extends along the fluid cavity, and divides the fluid cavity into at least two flow channels. In addition, any spoiler protrudes from the cover plate to the at least two flow channels, that is, the spoiler cannot block the flow channels.

When the chip heat dissipating lid provided in this application dissipates heat for the chip, the bottom plate is disposed close to the chip relative to the cover plate. In this way, heat dissipated by the chip is diffused to a cooling medium in the flow channel by using the bottom plate, and the heat is absorbed by using the cooling medium, to cool the chip.

When the cooling medium in the flow channel is used to dissipate heat for the chip, a cooling medium at a position in the flow channel close to the chip absorbs more heat, and a temperature rises faster. On the contrary, a cooling medium at a position in the flow channel far from the chip absorbs less heat, and a temperature rises slower. In this way, the cooling medium at the position in the flow channel far from the chip cannot be fully used.

In the chip heat dissipating lid provided in this application, there is at least one spoiler, and the spoiler protrudes from the cover plate to the flow channel. That is, a radial dimension of the flow channel may be changed by using the disposed spoiler. In this way, after the cooling medium flows through the spoiler, under the action of the spoiler, a flow rate of a cooling medium downstream of the spoiler is increased, thereby implementing mixing of high-temperature and low-temperature cooling media at different positions in the flow channel. In other words, a partial flow rate can be increased by using a spoiler effect of the spoiler, and heat dissipation performance can be improved. In a specific implementation, a position of the spoiler may be set based on a hot spot position of the chip. In this way, a hot spot of the chip may be quickly eliminated by using the spoiler, to improve use performance of the chip.

According to the first aspect, the at least one spoiler crosses the at least one separator.

In a possible implementation of the first aspect, a slot is provided on a part of the at least one separator close to the cover plate, and the at least one spoiler is inserted into the slot.

That is, the slot is provided on the separator to insert the spoiler into the slot. Compared with a welding procedure, the spoiler installed in this manner does not form interface thermal resistance, thereby improving a heat dissipation effect for the chip. In addition, the installation mode is simple and easy to implement.

In a possible implementation of the first aspect, there are a plurality of spoilers, and the plurality of spoilers are arranged at intervals along an extension direction of the flow channel.

In a specific implementation, the plurality of spoilers may be disposed based on a plurality of hot spots locations, to effectively eliminate a plurality of hot spots and improve the heat dissipation performance for the chip.

In a possible implementation of the first aspect, a spacing between a side surface of the spoiler close to the bottom plate and a bottom surface of the flow channel is D2, a depth of the flow channel along an engaging direction of the bottom plate and the cover plate is D1, and $\frac{D 2}{D 1} \leq 50 %$.

When the spoiler is disposed, if a spacing between the side surface of the spoiler close to the bottom plate and the bottom surface of the flow channel is large, the spoiler has a small spoiler effect, the flow rate of the cooling medium is increased slightly, and a mixing degree of the high-temperature and low-temperature cooling media is small. If the spacing between the side surface of the spoiler close to the bottom plate and the bottom surface of the flow channel is small, a cooling medium with a high flow rate quickly flows through the flow channel, thereby reducing a duration for exchanging heat and correspondingly reducing the heat dissipation effect. Therefore, it is required to set the spacing between the side surface of the spoiler close to the bottom plate and the bottom surface of the flow channel. For example, $\frac{D 2}{D 1} \leq 50 %$ may be set; and for another example, $\frac{D 2}{D 1} \leq 75 %$ may be set.

In a possible implementation of the first aspect, the spoiler and the cover plate constitute an integrated structure.

For example, when the installation mode that the slot is provided on the separator to insert the spoiler into the slot is used, if the spoiler and the cover plate constitute an integrated structure, and the cover plate and the bottom plate are fixed to each other, the spoiler may be directly inserted into the slot of the separator, and therefore it is convenient to install.

In a possible implementation of the first aspect, there are a plurality of separators, the plurality of separators are arranged in the fluid cavity at intervals, the plurality of separators and the bottom plate constitute an integrated structure, and the plurality of separators are arranged in a stepped manner along an arrangement direction thereof.

It may be understood that, the plurality of separators may be disposed on the bottom plate by using a skiving procedure, so that the plurality of separators are arranged in the stepped manner along the arrangement direction thereof.

When the separator and the bottom plate constitute an integrated structure by using the skiving procedure, compared with an existing manner in which the separator and the bottom plate are fixed to each other by using a welding procedure, a problem of large contact thermal resistance in an existing welding technology can be avoided. Because when the separator and the bottom plate have large contact thermal resistance, the heat dissipation effect for the chip is reduced. Therefore, the separator made by using the skiving procedure provided in this application reduces the contact thermal resistance and further improves the heat dissipation effect.

In a possible implementation of the first aspect, the bottom plate is a solid structure made of a metal material.

For example, a bottom plate structure may be made of copper metal.

In a possible implementation of the first aspect, when the bottom plate is the solid structure made of the metal material, an orthogonal projection on the chip and of an area in which the plurality of separators are located is located in an edge of the chip; or an orthogonal projection on the chip and of an area in which the plurality of separators are located coincides with an edge of the chip.

An objective of this setting is as follows: If the orthogonal projection on the chip and of the plurality of separators is located outside the edge of the chip, that is, when the plurality of separators occupy a large area, in a case in which a flow of a cooling medium flowing into an inlet port is fixed, a flow rate of a cooling medium in the flow channel between the plurality of separators occupying a large area is reduced. In this way, the heat dissipation effect for the chip is reduced. Therefore, the orthogonal projection on the chip and of the area in which the plurality of separators are located is located in the edge of the chip, or the orthogonal projection on the chip and of the area in which the plurality of separators are located coincides with the edge of the chip, thereby increasing the flow rate of the cooling medium and improving the heat dissipation performance.

In a possible implementation of the first aspect, a uniform temperature structure is disposed in the bottom plate, and the uniform temperature structure extends in a direction parallel to the chip. The uniform temperature structure is configured to diffuse, in the direction parallel to the chip, heat transferred to the bottom plate.

By disposing the uniform temperature structure, a transverse diffusion effect of the bottom plate (that is, the direction parallel to the chip) may be further improved, and finally, the heat dissipation effect for the chip may be further improved. For example, heat of the hot spot of the chip may be rapidly diffused in a plurality of directions by using the uniform temperature structure, to eliminate the hot spot as soon as possible.

In a possible implementation of the first aspect, the uniform temperature structure includes a wick embedded in the bottom plate, the wick has a coolant, and a cavity in the wick is a vacuum cavity. This structure may be referred to as a vapor chamber (vapor chamber, VC) structure, that is, heat may be diffused from a hot end to a cold end by using the wick. In addition, a cavity in a vacuum state may effectively reduce a boiling point of a coolant (for example, water), so that a phase change process of gas-liquid conversion occurs more quickly, and heat soaking performance of the VC is better.

In a possible implementation of the first aspect, the uniform temperature structure includes a first heat pipe embedded in the bottom plate. The chip heat dissipating lid further includes a second heat pipe, where the second heat pipe is embedded in the cover plate, and the second heat pipe is communicated with the first heat pipe.

It may be understood that the first heat pipe is disposed in the bottom plate, and the second heat pipe communicated with the first heat pipe is disposed in the cover plate. In this way, the first heat pipe may be used as the hot end, and the second heat pipe may be used as the cold end. Heat absorbed by the hot end is diffused to the cold end, and diffusion is performed to implement a uniform temperature, to improve the heat dissipation effect.

In a possible implementation of the first aspect, the chip heat dissipating lid further includes a first connection heat pipe and a second connection heat pipe. Both the first connection heat pipe and the second connection heat pipe are disposed outside the bottom plate and the cover plate that are engaging. The first connection heat pipe communicates one end of the first heat pipe with one end of the second heat pipe, and the second connection heat pipe communicates another end of the first heat pipe with another end of the second heat pipe.

In a possible implementation of the first aspect, the uniform temperature structure includes a filling structure embedded in the bottom plate, and a heat conductivity of the filling structure is greater than a heat conductivity of the bottom plate.

In other words, the uniform temperature is implemented by using the filling structure with the relatively large heat conductivity, to improve the heat dissipation effect.

In a possible implementation of the first aspect, the filling structure includes a diamond sheet. For example, when the bottom plate is made of the metallic copper material, and a heat conductivity of diamond is far greater than that of copper. In this way, heat can be quickly diffused through the diamond.

In a possible implementation of the first aspect, at least one drainage plate is disposed in the fluid cavity, and the at least one drainage plate protrudes from the cover plate to a port of the flow channel.

When the cooling medium in the flow channel is used to dissipate heat for the chip, the cooling medium at the position in the flow channel close to the chip absorbs more heat, and the temperature rises faster. On the contrary, the cooling medium at the position in the flow channel far from the chip absorbs less heat, and the temperature rises slower. In this way, the cooling medium at the position in the flow channel far from the chip cannot be fully used.

In this application, when the foregoing structure is used, a cooling medium flowing from the inlet port flows to a position of the flow channel close to the chip under a drainage effect of the drainage plate. In this way, in comparison with a case in which the cooling medium directly flows into the flow channel, by using the structure provided in this application, more heat is absorbed, thereby further improving the heat dissipation effect.

In a possible implementation of the first aspect, the fluid cavity includes a first area, and a second area located on one side of the first area. The at least one separator is located in the first area. A size of the second area in a first direction along a direction approaching the first area gradually increases. The first direction is a direction perpendicular to an arrangement direction of the first area and the second area.

When the size of the second area in the first direction along the direction approaching the first area gradually increases, compared with along the direction approaching the first area, the size of the second area in the first direction remains unchanged, and a difference between flow rates in a plurality of flow channels can be reduced, thereby correspondingly improving the heat dissipation effect.

The chip heat dissipating lid is used in a chip package structure, and is configured to dissipate heat for a chip. The chip heat dissipating lid includes a bottom plate and a cover plate engaging the bottom plate. A fluid cavity is formed between the bottom plate and the cover plate that are engaged. The chip heat dissipating lid further includes a plurality of separators, where the separators herein may also be referred to as fins. The plurality of separators are arranged in the fluid cavity at intervals, so that a flow channel is formed between two adjacent separators. The plurality of separators and the bottom plate constitute an integrated structure, and the plurality of separators are arranged in a stepped manner along an arrangement direction thereof.

It may be understood that, the plurality of separators may be disposed on the bottom plate by using a skiving procedure, and when the separators and the bottom plate constitute an integrated structure by using the skiving procedure, compared with an existing manner in which the separators and the bottom plate are fixed to each other by using a welding procedure, a problem of large contact thermal resistance in an existing welding technology can be avoided. Because when the separators and the bottom plate have large contact thermal resistance, a heat dissipation effect for the chip is reduced. Therefore, the separators made by using the skiving procedure provided in this application may reduce the contact thermal resistance and effectively improve the heat dissipation effect for the chip.

The chip heat dissipating lid further includes at least one spoiler, and the at least one spoiler protrudes from the cover plate to the flow channel.

When a cooling medium in the flow channel is used to dissipate heat for the chip, a cooling medium at a position in the flow channel close to the chip absorbs more heat, and a temperature rises faster. On the contrary, a cooling medium at a position in the flow channel far from the chip absorbs less heat, and a temperature rises slower. In this way, the cooling medium at the position in the flow channel far from the chip cannot be fully used.

In this application, a spoiler is disposed in the flow channel. After the cooling medium flows through the spoiler, under the action of the spoiler, a flow rate of a cooling medium downstream of the spoiler is increased, thereby implementing mixing of high-temperature and low-temperature cooling media at different positions in the flow channel. In other words, a partial flow rate can be increased by using a spoiler effect of the spoiler, and heat dissipation performance can be improved. In a specific implementation, a position of the spoiler may be set based on a hot spot position of the chip. In this way, a hot spot may be quickly eliminated by using the spoiler, to improve use performance of the chip.

The at least one spoiler crosses at least one separator.

In a possible implementation, a slot is provided on a part of at least one separator close to the cover plate, and the at least one spoiler is inserted into the slot.

That is, the slot is provided on the separator to insert the spoiler into the slot. Compared with a welding procedure, the spoiler installed in this manner does not form interface thermal resistance, thereby improving a heat dissipation effect for the chip. In addition, the installation mode is simple and easy to implement.

In a possible implementation, there are a plurality of spoilers, and the plurality of spoilers are arranged at intervals along an extension direction of the flow channel.

In a specific implementation, the plurality of spoilers may be disposed based on a plurality of hot spots locations, to effectively eliminate a plurality of hot spots and improve the heat dissipation performance.

In a possible implementation, a spacing between a side surface of the spoiler close to the bottom plate and a bottom surface of the flow channel is D2, a depth of the flow channel along an engaging direction of the bottom plate and the cover plate is D1, and $\frac{D 2}{D 1} \leq 50 %$.

When the spoiler is disposed, if a spacing between the side surface of the spoiler close to the bottom plate and the bottom surface of the flow channel is large, the spoiler has a small spoiler effect, the flow rate of the cooling medium is increased slightly, and a mixing degree of the high-temperature and low-temperature cooling media is small. If the spacing between the side surface of the spoiler close to the bottom plate and the bottom surface of the flow channel is small, a cooling medium with a high flow rate quickly flows through the flow channel, thereby reducing a duration for exchanging heat and correspondingly reducing the heat dissipation effect. Therefore, it is required to set the spacing between the side surface of the spoiler close to the bottom plate and the bottom surface of the flow channel. For example, $\frac{D 2}{D 1} \leq 50 %$ may be set; and for another example, $\frac{D 2}{D 1} \leq 75 %$ may be set.

In a possible implementation, the spoiler and the cover plate constitute an integrated structure.

For example, when the installation mode that the slot is provided on the separator to insert the spoiler into the slot is used, if the spoiler and the cover plate constitute an integrated structure, and the cover plate and the bottom plate are fixed to each other, the spoiler may be directly inserted into the slot of the separator.

In a possible implementation, the bottom plate is a solid structure made of a metal material.

For example, a bottom plate structure may be made of copper metal.

In a possible implementation, when the bottom plate is a solid structure made of a metal material, an orthogonal projection on the chip and of an area in which the plurality of separators are located is located in an edge of the chip; or an orthogonal projection on the chip and of an area in which the plurality of separators are located coincides with an edge of the chip.

An objective of this setting is as follows: If the orthogonal projection on the chip and of the plurality of separators is located outside the edge of the chip, that is, when the plurality of separators occupy a large area, in a case in which a flow of a cooling medium flowing into an inlet port is fixed, a flow rate of a cooling medium in the flow channel between the plurality of separators occupying a large area is reduced. In this way, the heat dissipation effect for the chip is reduced. Therefore, the orthogonal projection on the chip and of the area in which the plurality of separators are located is located in the edge of the chip, or the orthogonal projection on the chip and of the area in which the plurality of separators are located coincides with the edge of the chip, thereby improving the heat dissipation performance.

In a possible implementation, a uniform temperature structure is disposed in the bottom plate, and the uniform temperature structure extends in a direction parallel to the chip. The uniform temperature structure is configured to diffuse, in the direction parallel to the chip, heat transferred to the bottom plate.

By disposing the uniform temperature structure, a transverse diffusion effect of the bottom plate (that is, the direction parallel to the chip) may be further improved, and finally, the heat dissipation effect for the chip may be further improved. For example, heat of the hot spot of the chip may be rapidly diffused in a plurality of directions by using the uniform temperature structure, to eliminate the hot spot as soon as possible.

In a possible implementation, the uniform temperature structure includes a wick embedded in the bottom plate, the wick has a coolant, and a cavity in the wick is a vacuum cavity. This structure may be referred to as a vapor chamber (vapor chamber, VC) structure, that is, heat may be diffused from a hot end to a cold end by using the wick. In addition, a cavity in a vacuum state may effectively reduce a boiling point of water, so that a phase change process of gas-liquid conversion occurs more quickly, and heat soaking performance of the VC is better.

In a possible implementation, the uniform temperature structure includes a first heat pipe embedded in the bottom plate. The chip heat dissipating lid further includes a second heat pipe, where the second heat pipe is embedded in the cover plate, and the second heat pipe is communicated with the first heat pipe.

It may be understood that the first heat pipe is disposed in the bottom plate, and the second heat pipe communicated with the first heat pipe is disposed in the cover plate. In this way, the first heat pipe may be used as the hot end, and the second heat pipe may be used as the cold end. Heat absorbed by the hot end is diffused to the cold end, and diffusion is performed to implement a uniform temperature, to improve the heat dissipation effect.

In a possible implementation, the chip heat dissipating lid further includes a first connection heat pipe and a second connection heat pipe. Both the first connection heat pipe and the second connection heat pipe are disposed outside the bottom plate and the cover plate that are engaged. The first connection heat pipe communicates one end of the first heat pipe with one end of the second heat pipe, and the second connection heat pipe communicates another end of the first heat pipe with another end of the second heat pipe.

In a possible implementation, the uniform temperature structure includes a filling structure embedded in the bottom plate, and a heat conductivity of the filling structure is greater than a heat conductivity of the bottom plate.

In other words, the uniform temperature is implemented by using the filling structure with the relatively large heat conductivity, to improve the heat dissipation effect.

In a possible implementation, the filling structure includes a diamond sheet. For example, when the bottom plate is made of the metallic copper material, and a heat conductivity of diamond is far greater than that of copper. In this way, heat can be quickly diffused through the diamond.

In a possible implementation, at least one drainage plate is disposed in the fluid cavity, and the at least one drainage plate protrudes from the cover plate to a port of the flow channel.

When the cooling medium in the flow channel is used to dissipate heat for the chip, the cooling medium at the position in the flow channel close to the chip absorbs more heat, and the temperature rises faster. On the contrary, the cooling medium at the position in the flow channel far from the chip absorbs less heat, and the temperature rises slower. In this way, the cooling medium at the position in the flow channel far from the chip cannot be fully used.

In this application, when the foregoing structure is used, a cooling medium flowing from the inlet port flows to a position of the flow channel close to the chip under a drainage effect of the drainage plate. In this way, in comparison with a case in which the cooling medium directly flows into the flow channel, more heat is absorbed, thereby improving the heat dissipation effect.

In a possible implementation of the second aspect, the fluid cavity includes a first area, and a second area located on one side of the first area. At least one separator is located in the first area. A size of the second area in a first direction along a direction approaching the first area gradually increases. The first direction is a direction perpendicular to an arrangement direction of the first area and the second area.

When the size of the second area in the first direction along the direction approaching the first area gradually increases, compared with along the direction approaching the first area, the size of the second area in the first direction remains unchanged, and a difference between flow rates in a plurality of flow channels can be reduced, thereby correspondingly improving the heat dissipation effect.

This application further provides a chip package structure, including a package substrate, a chip disposed on the package substrate, and the chip heat dissipating lid in any implementation of the first aspect. The chip heat dissipating lid covers a side of the chip away from the package substrate.

In the chip package structure provided in this application, because the chip heat dissipating lid of the foregoing structure is included, a heat dissipation path from a heat source chip to a cooling medium in a flow channel is short, so that a heat dissipation effect can be improved. In addition, because the chip heat dissipating lid directly covers the chip, a height of the entire chip package structure can be reduced, and space occupied by the chip package structure can be reduced. In addition, a spoiler is disposed in a fluid cavity, so that a hot spot of the chip can be quickly eliminated, to improve use performance of the chip.

In a possible implementation, a concave cavity is formed on a side surface of a bottom plate facing the chip, the chip is enclosed in the concave cavity, and the bottom plate is connected to the package substrate by using an adhesive layer.

That is, the chip heat dissipating lid is connected to the package substrate by using the adhesive layer, and compared with a structure in which the chip heat dissipating lid is connected to the package substrate by using a connecting piece such as a bolt, a phenomenon of large extrusion on the chip can be avoided on the premise that a connection strength between the chip heat dissipating lid and the package substrate is ensured.

In a possible implementation, a concave cavity is formed on a side surface of a cover plate facing the chip, the bottom plate and the chip are both enclosed in the concave cavity, and the cover plate is connected to the package substrate by using an adhesive layer.

In a possible implementation, an orthogonal projection on the chip and of an area in which at least one separator is located is located in an edge of the chip; or an orthogonal projection on the chip and of an area in which at least one separator is located coincides with an edge of the chip.

In a case in which the flow remains unchanged, compared with a case in which an orthogonal projection on the chip and of an area in which at least one separator is located is located outside an edge of the chip, a flow rate of the cooling medium in the flow channel can be increased, thereby improving the heat dissipation performance.

### BRIEF DESCRIPTION OF DRAWINGS

FIG. 1 is a schematic diagram of a structure including a PCB, a chip, and a cold plate that dissipates heat for the chip in a conventional technology;
FIG. 2 is a schematic diagram of a simple structure of a device interconnection system;
FIG. 3 is a schematic diagram of a structure including a PCB, a chip, and a heat dissipating lid that dissipates heat for the chip helpful for understanding the invention but not covered by the claims;
FIG. 4 is a cross section view of a heat dissipating lid according to this application;
FIG. 5 is an exploded view of FIG. 4;
FIG. 6 is a 3D diagram of a bottom plate and a separator in a heat dissipating lid helpful for understanding the invention but not covered by the claims;
FIG. 7 is a top view of a bottom plate and a separator in a heat dissipating lid helpful for understanding the invention but not covered by the claims;
FIG. 8 is a schematic diagram of a structure including a PCB, a chip, and a heat dissipating lid that dissipates heat for the chip according to this application;
FIG. 9 is a schematic diagram of a structure including a PCB, a chip, and a heat dissipating lid that dissipates heat for the chip helpful for understanding the invention but not covered by the claims;
FIG. 10 is a 3D diagram of a heat dissipating lid having a first separator, a second separator, and a bottom plate helpful for understanding the invention but not covered by the claims;
FIG. 11 is an M-side view of FIG. 10;
FIG. 12 is a cross section view of a heat dissipating lid according to this application;
FIG. 13 is an exploded view of FIG. 12;
FIG. 14 is an exploded view of a separator and a spoiler in a heat dissipating lid according to this application;
FIG. 15 is an N-side view of FIG. 14;
FIG. 16 is a schematic view of disposing a spoiler for spoiling;
FIG. 17 is a schematic diagram of a structure of a separator and a spoiler in a heat dissipating lid according to this application;
FIG. 18a is a schematic diagram of a position relationship between two separators and a spoiler according to this application;
FIG. 18b is a schematic diagram of a position relationship between two separators and a spoiler according to this application;
FIG. 19a is a schematic diagram of a cross-sectional structure of a spoiler according to this application;
FIG. 19b is a schematic diagram of a cross-sectional structure of a spoiler according to this application;
FIG. 19c is a schematic diagram of a cross-sectional structure of a spoiler according to this application;
FIG. 19d is a schematic diagram of a cross-sectional structure of a spoiler according to this application;
FIG. 19e is a schematic diagram of a cross-sectional structure of a spoiler according to this application;
FIG. 19f is a schematic diagram of a cross-sectional structure of a spoiler according to this application;
FIG. 19g is a schematic diagram of a cross-sectional structure of a spoiler according to this application;
FIG. 20 is a schematic diagram of a structure including a PCB, a chip, and a heat dissipating lid that dissipates heat for the chip according to this application;
FIG. 21a is a cross section view of a heat dissipating lid according to this application;
FIG. 21b is a cross section view of a heat dissipating lid according to this application;
FIG. 21c is an exploded view of FIG. 21b;
FIG. 22 is a cross section view of a heat dissipating lid according to this application;
FIG. 23a is a top view of a bottom plate and a separator in a heat dissipating lid according to this application;
FIG. 23b is a top view of a bottom plate and a separator in a heat dissipating lid according to this application;
FIG. 23c is a top view of a bottom plate and a separator in a heat dissipating lid according to this application;
FIG. 24 is a schematic diagram of a structure including a PCB, a chip, and a heat dissipating lid that dissipates heat for the chip according to this application;
FIG. 25 is a schematic diagram of a structure of a bottom plate in FIG. 24;
FIG. 26 is a schematic diagram of a structure of a cover plate in FIG. 24;
FIG. 27a, FIG. 27b, FIG. 27c, FIG. 27d, and FIG. 27e are corresponding schematic diagrams of structures after steps in a method for preparing a plurality of separators are completed according to this application;
FIG. 28a, FIG. 28b, FIG. 28c, and FIG. 28d are corresponding schematic diagrams of structures after steps in a method for preparing a heat dissipating lid are completed according to this application;
FIG. 29 is a cross section view of a heat dissipating lid according to this application;
FIG. 30 is a cross section view of a heat dissipating lid according to this application;
FIG. 31 is a schematic diagram of a structure including a PCB, a chip, and a heat dissipating lid that dissipates heat for the chip according to this application;
FIG. 32a, FIG. 32b, FIG. 32c, and FIG. 32d are corresponding schematic diagrams of structures after steps in a method for preparing a heat dissipating lid are completed according to this application;
FIG. 33 is a cross section view of a heat dissipating lid according to this application;
FIG. 34 is a cross section view of a heat dissipating lid according to this application;
FIG. 35 is a schematic diagram of a structure including a PCB, a chip, and a heat dissipating lid that dissipates heat for the chip according to this application;
FIG. 36a, FIG. 36b, FIG. 36c, and FIG. 36d are corresponding schematic diagrams of structures after steps in a method for preparing a heat dissipating lid are completed according to this application;
FIG. 37 is a cross section view of a heat dissipating lid according to this application;
FIG. 38 is a schematic diagram of a structure including a PCB, a chip, and a heat dissipating lid that dissipates heat for the chip according to this application; and
FIG. 39a, FIG. 39b, FIG. 39c, and FIG. 39d are corresponding schematic diagrams of structures after steps in a method for preparing a heat dissipating lid are completed according to this application.

Reference numerals:
1-Package substrate; 2-Chip; 21-First chip; 22-Second chip; 3-First TIM layer; 4-Cover plate; 5-Second TIM layer; 6-Cold plate; 61-Fin; 62-Water channel; 63-Liquid inlet port; 64-Liquid outlet port;
01-Rack; 02-PCB; 03-First electrical connection structure; 04-Second electrical connection structure; 05-Heat dissipating lid; 06-Adhesive layer; 07, 071, 072-TIM layers; 08-Cooling structure; 081-First port; 082-Second port; 10-Chip package structure;
11-Bottom plate; 111-Wick; 112-Support column; 113-Concave cavity; 12-Cover plate; 121-Drainage plate; 122-Cavity; 123-Sealing plate; 131-Inlet port; 132-Outlet port; 133-Third port; 14-Fluid cavity; 15-Separator; 151-First separator; 1511-First slot; 152-Second separator; 1521-Second slot; 16, 161, 162, 163, 164-Flow channels; 17-Spoiler; 171-First spoiler; 172-Second spoiler; 181, 182-Heat dissipation channels; 183-Connection heat pipe; 19-Filling structure.

### DESCRIPTION OF EMBODIMENTS

Embodiments of this application provide a device interconnection system. For example, the device interconnection system may include a server (server), or may be a data center (data center), or may be another interconnection device.

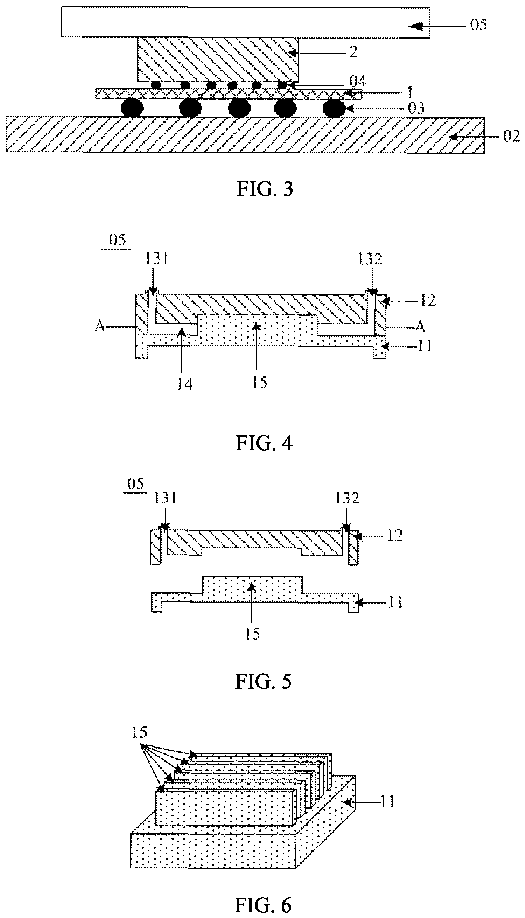

FIG. 2 is a schematic diagram of a simple structure of a server. The server includes a rack 01, a printed circuit board (printed circuit board, PCB) 02 disposed in the rack 01, and an electronic component integrated on the PCB 02. As shown in FIG. 3, a package substrate 1 is disposed on the PCB 02, a chip 2 is disposed on the package substrate 1, the package substrate 1 is electrically connected to the PCB 02 by using a first electrical connection structure 03, and the chip 2 is electrically connected to the package substrate 1 by using a second electrical connection structure 04.

The first electrical connection structure 03 may be a ball grid array (ball grid array, BGA), or a plurality of copper pillar bumps (copper pillar bump) arranged in an array, or the like.

The second electrical connection structure 04 may be a controlled collapse chip connection welding joint (controlled collapse chip connection, C4), a micro bump (Micro Bump, uBump), or the like.

In a structure shown in FIG. 3, only one chip integrated on the package substrate 1 is shown. There may also be a plurality of stacked chips integrated by using 3D.

In addition, a heat dissipating lid (heat dissipating lid, HDL) 05 is further disposed on the chip. The heat dissipating lid 05 not only serves as a structure for protecting the chip 2, but is also configured to diffuse heat dissipated by the chip 2, so that the chip 2 operates normally at a proper temperature.

In these large device interconnection systems, as a quantity of chip cores and a computing speed increase, heat dissipated also increases, which brings a challenge to a heat dissipation effect of a heat dissipating lid structure. Especially in some conditions such as that a large space cannot be occupied, a chip cannot be extruded, a heat dissipation path is short, or a hot spot is quickly eliminated, it is more difficult to improve the heat dissipating lid structure.

FIG. 4 shows a cross section view of a heat dissipating lid 05. FIG. 5 is an exploded view of FIG. 4. With reference to FIG. 4 and FIG. 5, the heat dissipating lid 05 includes a bottom plate 11 and a cover plate 12, and the bottom plate 11 and the cover plate 12 are engaged with and fixed to each other. For example, the bottom plate 11 and the cover plate 12 may be fixedly connected by using a welding procedure (for example, laser welding), or the bottom plate 11 and the cover plate 12 may be fixed to each other by using an adhesive (adhesive, AD).

With further reference to FIG. 4, a fluid cavity 14 is formed between the bottom plate 11 and the cover plate 12 that are engaged, and an inlet port 131 and an outlet port 132 that are communicated with the fluid cavity 14 are provided on the bottom plate 11 and the cover plate 12 that are engaged. For example, when the bottom plate 11 and the cover plate 12 that are engaged cover a chip, heat dissipated by the chip is diffused into the fluid cavity 14, and when a cooling medium flowing from the inlet port 131 flows through the fluid cavity 14, the cooling medium absorbs heat and flows out from the outlet port 132.

In FIG. 4 and FIG. 5, the bottom plate 11 and the cover plate 12 are two independent structures, and the fluid cavity 04 is formed after the bottom plate 11 is engaging the cover plate 12. In some other examples, the heat dissipating lid 05 may be formed by using an integrated structure, and the fluid cavity 14 is formed in the integrally formed heat dissipating lid 05.

When the heat dissipating lid 05 shown in FIG. 4 and FIG. 5 is used, the bottom plate 11 is disposed close to the chip relative to the cover plate 12. In this way, to reduce thermal resistance, so that most heat dissipated by the chip is diffused to the fluid cavity 14 by using the bottom plate 11, the bottom plate 11 needs to be made of a material with high heat conductivity. For example, metal may be used, and the metal may be copper (Cu), aluminum (Al), or the like. In addition, because the cover plate 12 is far from the chip relative to the bottom plate 11, a heat conductivity of the cover plate 12 may be the same as that of the bottom plate 11. For example, the metal is selected for both the cover plate 12 and the bottom plate 11, or another material such as plastic may be selected. Materials of the bottom plate 11 and the cover plate 12 are not specially limited in this application. When the heat dissipating lid 05 is of an integrated structure, the heat dissipating lid 05 structure may be made by using a metal material.

In addition, the cooling medium that flows through the fluid cavity 14 in this application may be liquid, for example, water. Another cooling liquid may also be selected. Alternatively, a cooling medium, which is liquid at an inlet and becomes gas to flow out from an outlet after absorbing heat in the fluid cavity, may be selected.

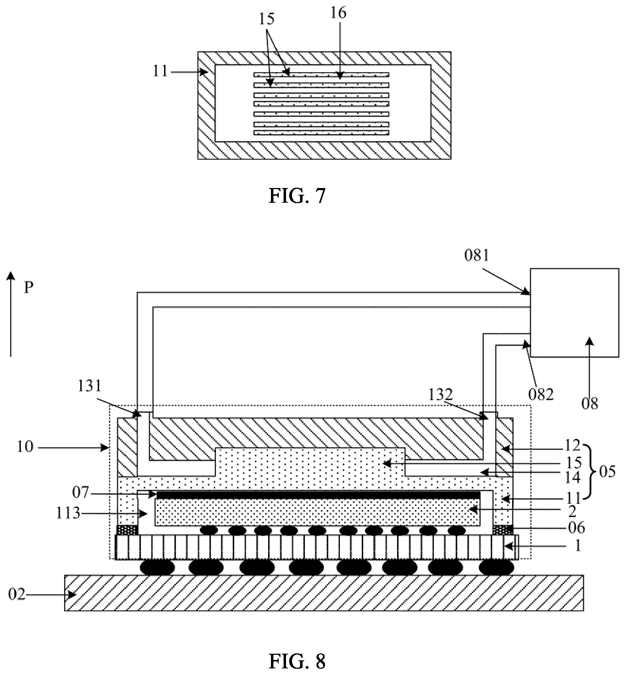

With reference to FIG. 4 and FIG. 5, at least one separator 15 is further disposed in the fluid cavity 14. The separator 15 may also be referred to as a fin (Fin). The at least one separator 15 extends along the fluid cavity 14, and divides the fluid cavity 14 into at least two flow channels. For example, one separator 15 extends in a curved shape in the fluid cavity 14, so that two flow channels are formed in the fluid cavity. For another example, FIG. 6 is a 3D diagram of the structure in FIG. 4 with the cover plate 12 removed. As can be seen from FIG. 6, the heat dissipating lid 05 includes a plurality of separators 15 disposed at intervals. FIG. 7 is an A-A cross section view of FIG. 4. As can be seen from FIG. 7, a flow channel 16 is formed between every two adjacent separators 15.

A quantity of separators 15 and a spacing between two adjacent separators 15 may be set based on power consumption of the chip. For example, when the power consumption of the chip is about 1000 W, a spacing between two adjacent separators 15 may be 0.2 mm or 0.1 mm, to form an ultra-dense fin structure.

In FIG. 7, because each separator 15 is of a straight line structure, a formed flow channel 16 is also of a straight line structure. In another optional example, each separator 15 may also extends in a curve, to form a flow channel 16 that extends in a curve. In this way, a heat conduction area may be increased, and a heat dissipation effect may be improved.

A structure shown in FIG. 8 includes a cooling structure 08, a PCB 02, and a chip package structure 10 integrated on the PCB 02. The chip package structure 10 includes a package substrate 1 and a chip 2 disposed on the package substrate 1, the package substrate 1 is disposed on the PCB 02, and further includes the heat dissipating lid 05 shown above. The heat dissipating lid 05 covers one side of the chip 2 away from the package substrate 1, that is, located above the chip 2. The bottom plate 11 of the heat dissipating lid 05 is close to the chip 2 relative to the cover plate 12. In addition, a concave cavity 113 is provided on a side surface of the bottom plate 11 facing the chip 2, the chip 2 is enclosed in the concave cavity 113, a TIM layer 07 is disposed between the bottom plate 11 and the chip 2, and the bottom plate 11 is bonded to the package substrate 1 by using an adhesive layer 06.

In addition, the cooling structure 08 included in the structure shown in FIG. 8 has a first port 081 and a second port 082, where the first port 081 is communicated with the inlet port 131, and the second port 082 is communicated with the outlet port 132. The cooling structure 08 is configured to cool the cooling medium flowing into the fluid cavity 04. In this way, a cooling medium having a low temperature is guided into the fluid cavity 04, so that a larger temperature difference and a better cooling effect can be achieved.

As can be seen from the structure shown in FIG. 8, heat dissipated by the chip 2 may enter the fluid cavity 14 after passing through the TIM layer 07 and the bottom plate 11, and the heat is diffused by using a cooling medium flowing in a plurality of flow channels. Compared with the conventional technologies, in a heat dissipation manner shown in FIG. 8, a heat dissipation path between the heat source chip 2 and the flow channel is significantly shortened. In this way, the heat dissipation effect is significantly improved.

In addition, because the heat dissipation path between the heat source chip 2 and the flow channel is short, a height size of the separator 15 in a direction P shown in FIG. 8 does not need to be designed high. For example, the height size of the separator 15 may be about 3 mm. In addition, because the heat dissipating lid 05 directly covers the chip 2, compared with the conventional technologies, a cover plate structure covering the chip 2 is omitted. In this way, a height size of the entire structure shown in FIG. 8 in the P direction is significantly shorter than that in the conventional technologies, thereby reducing a space occupied in a rack.

In addition, as can be seen from FIG. 8, the TIM layer 07 and the bottom plate 11 are disposed between the cooling medium in the fluid cavity 14 and a surface of the chip 2. Compared with an existing impact jet liquid cooling technology, the cooling medium is prevented from directly contacting the chip 2, and reliability risks such as leakage caused by direct contact between the cooling medium and the chip (die) are reduced.

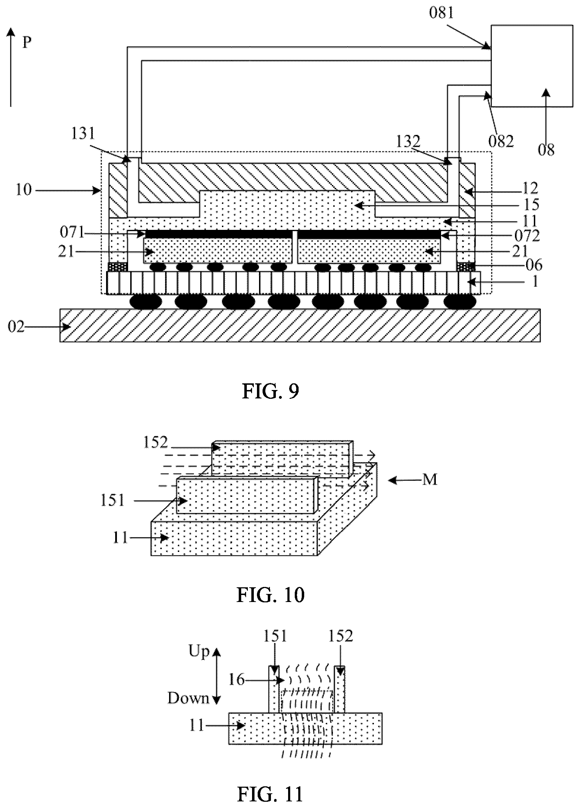

In the structure shown in FIG. 8, the TIM layer 07 may be made of an indium sheet. Compared with the structure shown in FIG. 8, in FIG. 9, the chip includes a first chip 21 and a second chip 22, a TIM layer 071 is disposed between the first chip 21 and the bottom plate 11, and a TIM layer 072 is disposed between the second chip 22 and the bottom plate 11. When the TIM layer 071 and the TIM layer 072 are made of a material such as an indium sheet, because the material such as an indium sheet has poor liquidity, after the TIM layer is formed on surfaces of the first chip 21 and the second chip 22, a chip grinding (die grounding) procedure is not required, because the chip may be damaged when the chip grinding procedure is performed. Therefore, the heat dissipating lid structure provided in this application can further ensure a yield of the chip package structure.

In addition, in this application, the bottom plate 11 of the heat dissipating lid 05 may be bonded to the package substrate 1 by using the adhesive layer 06. Compared with an existing manner in which the heat dissipating lid is fixedly connected to the PCB by using a connecting piece such as a bolt, this can avoid large extrusion on the chip or even damage to the chip during installation of the heat dissipating lid.

FIG. 10 shows a first separator 151 and a second separator 152 that are adjacent among a plurality of separators 15, and the bottom plate 11. FIG. 11 is an M-side view of FIG. 10. As shown in FIG. 11, when the bottom plate 11 is disposed close to the chip, and heat of the chip is diffused to a flow channel 16 between the first separator 151 and the second separator 152, heat carried by a cooling medium (as shown in a dashed line box in FIG. 11) close to the bottom plate 11 is significantly higher than heat carried by a cooling medium away from the bottom plate 11. It may also be understood that, from bottom to top shown in FIG. 11, heat absorbed by the cooling medium gradually decreases. In this way, the cooling medium away from the bottom plate 11 cannot be fully used, thereby reducing a benefit rate of the cooling medium and affecting the heat dissipation effect for the chip, and in particular, for a chip with high power consumption and high power density, it is difficult to eliminate a local hot spot of the chip.

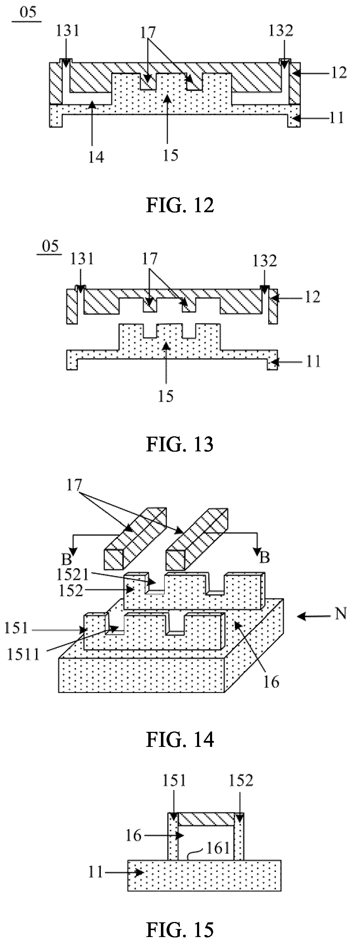

FIG. 12 shows a cross section view of another heat dissipating lid 05. FIG. 13 is an exploded view of FIG. 12. Similar to the heat dissipating lid 05 shown in FIG. 4 and FIG. 5, the heat dissipating lid 05 shown in FIG. 12 and FIG. 13 also includes a bottom plate 11 and a cover plate 12 that are engaged with and fixed to each other, a fluid cavity 14 formed in the bottom plate 11 and the cover plate 12, and at least one separator 15 disposed in the fluid cavity 14. Different from the heat dissipating lid 05 shown in FIG. 4 and FIG. 5, the heat dissipating lid 05 shown in FIG. 12 and FIG. 13 further includes at least one spoiler 17. The spoiler 17 protrudes from the cover plate 12 to a flow channel, but the spoiler 17 cannot block the flow channel. FIG. 12 and FIG. 13 show two spoilers 17 as an example. The two spoilers 17 are arranged at intervals along an extension direction of the flow channel.

FIG. 14 shows a manner of disposing the spoiler 17, and FIG. 14 shows a position relationship between the spoiler 17 and a first separator 151 and a second separator 152 among the plurality of separators. FIG. 14 is an exploded view, and FIG. 15 is an N-side view of the spoiler 17 in FIG. 14 after assembly. As shown in FIG. 14 and FIG. 15, the spoiler 17 is disposed in the flow channel 16 formed between the first separator 151 and the second separator 152. One end of the spoiler 17 is fixed to the first separator 151, and another end of the spoiler 17 is fixed to the second separator 152, that is, the spoiler 17 crosses between the adjacent first separator 151 and the second separator 152, and there is a spacing between the spoiler 17 and a bottom surface 161 of the flow channel 16. In this way, that a cooling medium smoothly flows through the flow channel 16 can be ensured.

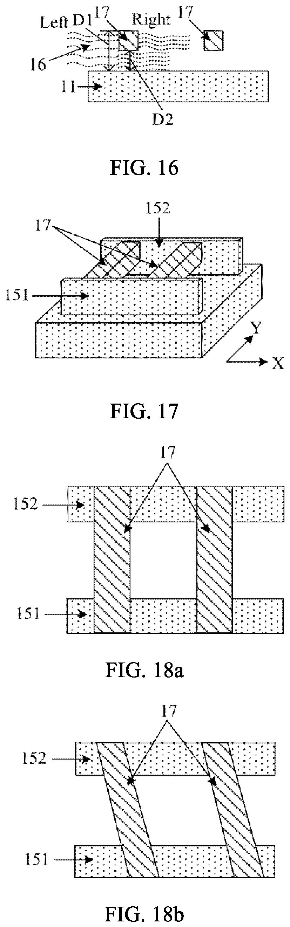

FIG. 16 is a B-B cross section view of FIG. 14. As shown in FIG. 16, when a cooling medium (a curved dashed line in FIG. 16) flows from left to right in the flow channel 16, and flows to a position in which the spoiler 17 is located, a depth of the flow channel 16 decreases from D1 to D2. According to a relationship of flow (S) = flow rate (V) × pipe radial dimension (D), when the depth of the flow channel 16 decreases from D1 to D2, the flow (S) remains unchanged while the flow rate (V) increases, and after the cooling medium flows through the position in which the spoiler 17 is located, a flow rate of the cooling medium increases. In this way, in a unit time, a cooling medium with a high flow rate absorbs more heat, thereby improving a heat dissipation effect for the chip.

The spoiler 17 may also be understood in this way. The spoiler 17 may increase a local area flow rate and mixing of high-temperature and low-temperature liquids, and increase a local flow rate to improve heat dissipation performance. For example, the spoiler 17 may be disposed above a hot spot of the chip, that is, the spoiler 17 is configured to improve the heat dissipation effect, eliminate the hot spot, and improve chip performance.

In some optional implementations, a relationship between D1 and D2 may be $\frac{D 2}{D 1} \leq 50 %$, or $\frac{D 2}{D 1} \leq 75 %$. Because when a distance between the spoiler 17 and the bottom surface 161 of the flow channel 16 is too large, D1 is close to D2, the spoiler 17 has a small spoiler effect, and has a little impact on the flow rate of the cooling medium. In addition, the distance between the spoiler 17 and the bottom surface of the flow channel 16 cannot be too small, because a cooling medium with a high flow rate quickly flows through the flow channel, thereby reducing a duration for exchanging heat and correspondingly reducing the heat dissipation effect, and further increasing a pressure drop at an inlet port and an outlet port of the entire heat dissipating lid.

In a case in which the spoiler 17 crosses between two adjacent separators 15, there are a plurality of modes of connecting the spoiler 17 to the two adjacent separators 15.

For example, as shown in FIG. 14, a first slot 1511 may be provided on the first separator 151, and a second slot 1521 may be provided on the second separator 152. One end of the spoiler 17 is inserted into the first slot 1511, and another end of the spoiler 17 is inserted into the second slot 1521.

For another example, as shown in FIG. 17, no slot is provided on the first separator 151 and the second separator 152 that are adjacent, but the spoiler 17 is welded between the first separator 151 and the second separator 152 by using a welding procedure.

If the installation mode shown in FIG. 17 is used, because the welding procedure is used, large interface thermal resistance is introduced at a joint between the spoiler 17 and the separator 15, and the heat dissipation effect for the chip is reduced. Especially, when a plurality of separators are arranged along a Y direction shown in FIG. 17, because the spoiler 17 needs to be welded between every two adjacent separators, the introduced interface thermal resistance is larger. In addition, the welding manufacturing procedure is also complex.

However, when the connection manner shown in FIG. 14 is used, the spoiler 17 and the cover plate 12 constitute an integrated structure. When the cover plate 12 is engaging the bottom plate 11, the spoiler 17 is directly inserted into the first slot 1511 and the second slot 1521. The installation procedure is convenient. In addition, no other welding procedure is introduced, and the interface thermal resistance does not reduce the heat dissipation effect for the chip.

There are a plurality of modes of arranging the spoilers 17 on the two adjacent separators 15.

For example, FIG. 18a is a top view of a first separator 151, a second separator 152, and two spoilers 17. An extension direction of the spoilers 17 is perpendicular to an extension direction of the first separator 151 and the second separator 152.

For another example, FIG. 18b is also a top view of a first separator 151, a second separator 152, and two spoilers 17. The spoilers 17 are obliquely disposed between the first separator 151 and the second separator 152.

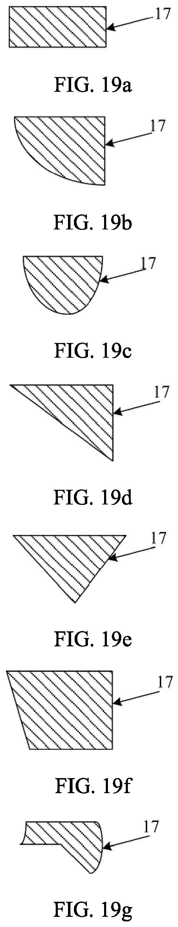

A cross section of the spoiler 17 also has a plurality of shapes. FIG. 19a to FIG. 19g show a plurality of structures of the spoiler 17 with cross sections of different shapes.

For example, in FIG. 19a, a spoiler 17 with a cross section of a rectangular structure is used.

For another example, in FIG. 19b and FIG. 19c, a spoiler 17 with a cross section of a fan-shaped structure is provided.

For another example, in FIG. 19d and FIG. 19e, a spoiler 17 with a cross section of a triangular structure is provided.

For another example, in FIG. 19f, a spoiler 17 with a cross section of a trapezoidal structure is provided.

For another example, in FIG. 19g, a spoiler 17 with a cross section of an irregular structure is provided.

A specific shape of the spoiler 17 is not specifically limited in this application, and any structure falls within a protection scope of this application.

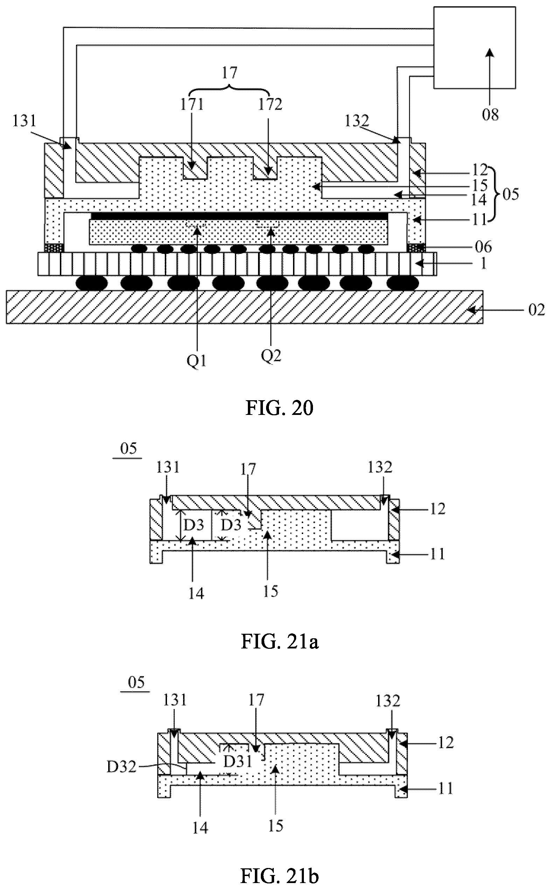

A structure shown in FIG. 20 includes a heat dissipating lid 05 configured to dissipate heat for a chip 2. The structure shown in FIG. 20 also includes a package substrate 1, the chip 2 disposed on the package substrate 1, a PCB 02 carrying the package substrate 1, and the heat dissipating lid 05 covering the chip 2. In addition, a spoiler 17 is disposed between two adjacent separators 15 of the heat dissipating lid 05. A structure and an arrangement manner of the spoiler 17 herein may be any one of the foregoing structures and arrangement manners.

With further reference to FIG. 20, for example, when the chip 2 has a first hot spot Q1 and a second hot spot Q2 with high heat dissipation, a first spoiler 171 may be disposed above the first hot spot Q1, and a second spoiler 172 may be disposed above the second hot spot Q2. In an optional embodiment, an orthogonal projection of the first spoiler 171 on the chip 2 may cover the first hot spot Q1, and an orthogonal projection of the second spoiler 172 on the chip 2 may cover the second hot spot Q2. In this way, when more heat dissipated by the first hot spot Q1 and the second hot spot Q2 is diffused to a flow channel, the heat dissipated by the first hot spot Q1 and the second hot spot Q2 may be carried away as soon as possible by using a cooling medium with a high flow rate at the first spoiler 171 and the second spoiler 172, to achieve an objective of quickly eliminating the hot spot.

In a specific implementation, a quantity of spoilers 17 may be determined based on a quantity of hot spots of the chip 2. The quantity of spoilers 17 is not limited in this application. In addition, a disposing position of the spoiler 17 may be determined based on a hot spot position.

FIG. 21a and FIG. 21b further provide two heat dissipating lids 05 of different structures. Upon comparison, in FIG. 21a, a depth D3 of the flow channel is equal to a depth D3 at a position of a fluid cavity 14 close to a port of the flow channel, while in FIG. 21b, a depth of the flow channel is D31, a depth at the position of the fluid cavity 14 close to the port of the flow channel is D32, and D32 is less than D31.

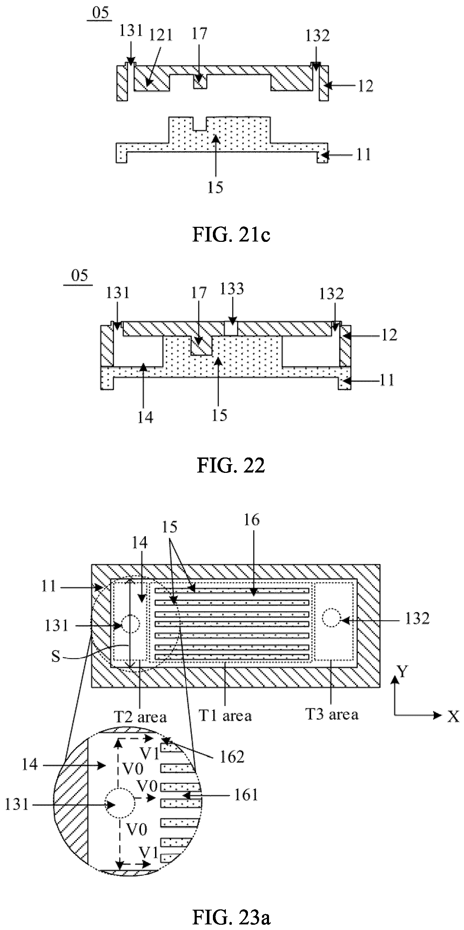

FIG. 21c is an exploded view of FIG. 21b. As shown in FIG. 21b and FIG. 21c, a drainage plate 121 is disposed in the fluid cavity 14, and the drainage plate 121 protrudes from a cover plate 12 to the port of the flow channel. In other words, there is a spacing between a side surface of the drainage plate 121 close to a bottom plate 11 and a bottom surface of the fluid cavity 14, that is, the drainage plate 121 cannot block the port of the flow channel. In this way, the structure in which D32 is less than D31 shown in FIG. 21b may be formed. The port of the flow channel herein may be an inlet or an outlet of the flow channel.

When dissipating heat for the chip, a cooling medium flowing in a space of the flow channel close to the chip may absorb more heat. Therefore, when the structures shown in FIG. 21b and FIG. 21c are used, the drainage plate 121 is disposed, so that a cooling medium flowing into the flow channel through an inlet port 131 flows toward a bottom space of the flow channel under the action of the drainage plate 121, that is, flows toward a direction approaching the chip, to quickly absorb heat dissipated by the chip. In some optional implementations, as shown in FIG. 21c, the drainage plate 121 and the cover plate 12 constitute an integrated structure.

The inlet port 131 and an outlet port 132 of the heat dissipating lid 5 may be disposed in various positions.

For example, as shown in FIG. 21a to FIG. 21c, the inlet port 131 and the outlet port 132 are disposed on the top of the cover plate 12, where the inlet port 131 and the outlet port 132 are disposed on two ends of the fluid cavity 14, and there may be one inlet port 131 and one outlet port 132.

For another example, as shown in FIG. 22, not only the inlet port 131 and the outlet port 132 are included, but also a third port 133 is included. The inlet port 131 and the outlet port 132 are disposed at two ends of the fluid cavity 14, and the third port 133 is disposed in the middle of the fluid cavity 14. The third port 133 may be used as an inlet, and both the inlet port 131 and the outlet port 132 may be used as an outlet. Alternatively, the third port 133 may be used as an outlet, and both the inlet port 131 and the outlet port 132 may be used as an inlet.

The structure of the fluid cavity 14 in this application also has a plurality of shapes. FIG. 23a to FIG. 23c show structures of the fluid cavity 14 in different shapes.

Based on these structures of the fluid cavity 14 of different shapes, the fluid cavity 14 may be understood in this way. As shown in FIG. 23a, the fluid cavity 14 includes a first area T1 configured to dispose the separator 15, and a second area T2 located on one side of the first area T1, or further includes a third area T3 located on the other side of the first area T1. In the structure shown in FIG. 23a, the inlet port 131 is communicated with the second area T2, the outlet port 132 is communicated with the third area T3. An arrangement direction of the second area T2, the first area T1, and the third area T3 may be defined as a first direction X direction, and a direction perpendicular to the arrangement direction of the second area T2, the first area T1, and the third area T3 is a second direction Y direction. For example, in FIG. 23a, arrangement directions of a plurality of flow channels 16 are arranged along the second direction Y direction.

In FIG. 23a, from the second area T2 to the first area T1, or from the third area T3 to the first area T1, a size (for example, a size S in FIG. 23a) of the fluid cavity 14 in the second direction Y direction is unchanged. In this way, a structure of the fluid cavity 14 with a rectangular cross section shown in FIG. 23a may be formed.

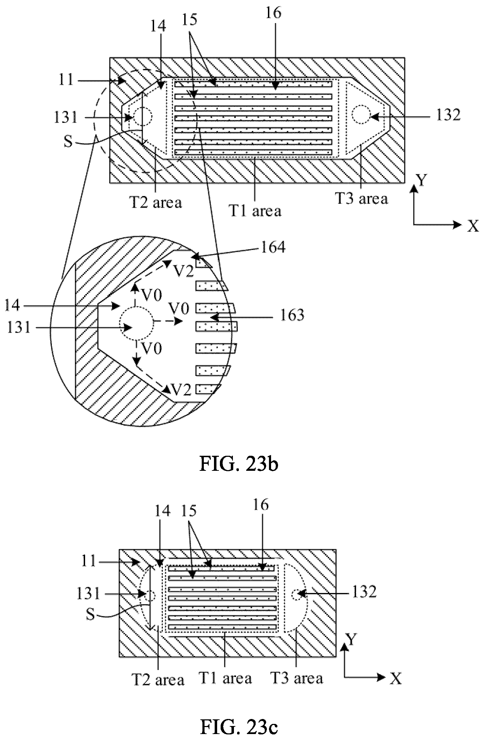

In FIG. 23b and FIG. 23c, from the second area T2 to the first area T1, or from the third area T3 to the first area T1, a size (for example, a size S in FIG. 23b) of the fluid cavity 14 in the second direction Y direction gradually increases. However, in FIG. 23b, the cross sections of the second area T2 and the third area T3 are fan-shaped structures, and in FIG. 23c, the cross sections of the second area T2 and the third area T3 are trapezoid structures. Specifically, the cross sections of the second area T2 and the third area T3 may alternatively be in another shape.

A flow condition of the cooling medium in the fluid cavity 14 is explained with reference to an enlarged diagram in FIG. 23a and an enlarged diagram in FIG. 23b.

In the enlarged diagram in FIG. 23a, after the cooling medium flows into the second area T2 from the inlet port 131, part of the cooling medium flows in the X direction at a flow rate V0, and part of the cooling medium flows in the Y direction at the flow rate V0. The cooling medium flowing in the X direction directly flows into a flow channel 161 to absorb heat dissipated by the chip. However, after the cooling medium flowing in the Y direction is in contact with a side wall of the fluid cavity 14, the flow rate decreases to V1, and then the cooling medium flows into a flow channel 162, as a result, a flow rate of the cooling medium in the flow channel 162 is less than a flow rate of the cooling medium in the flow channel 161. Therefore, in the plurality of flow channels, the flow rate of the cooling medium is low in a flow channel far from the inlet port 131, and a corresponding heat dissipation effect is poorer.

In the enlarged diagram in FIG. 23b, after the cooling medium flows into the second area T2 from the inlet port 131, part of the cooling medium flows in the X direction at the flow rate V0, and part of the cooling medium flows in the Y direction at the flow rate V0. The cooling medium flowing in the X direction directly flows into a flow channel 163 to absorb heat dissipated by the chip. However, after the cooling medium flowing in the Y direction is in contact with the side wall of the fluid cavity 14, the flow rate decreases to V2, and then the cooling medium flows into a flow channel 164.

A difference between the structures shown in FIG. 23b and FIG. 23a is that, along the X direction, a size of the second area T2 gradually increases in the second direction Y direction. In this way, it may be understood that, compared with FIG. 23a, the flow rate of the cooling medium decreases slowly in the Y direction in FIG. 23b. Therefore, V2 in FIG. 23b is greater than V1 in FIG. 23a, and in a unit time, a heat dissipation effect of the structure shown in FIG. 23b is better than a heat dissipation effect of the structure shown in FIG. 23a.

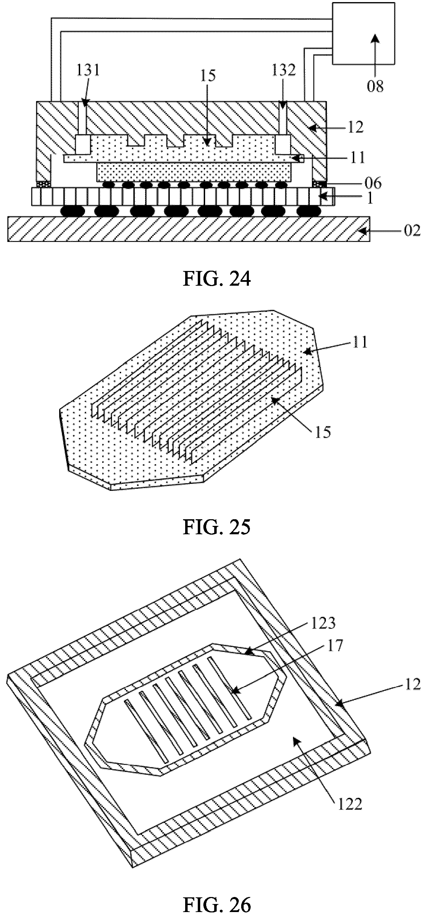

In the heat dissipating lid 05 shown above, the bottom plate 11 is connected to the package substrate 1 by using an adhesive layer 06. FIG. 24 further provides another heat dissipating lid structure. In the heat dissipating lid structure, a cover plate 12 is connected to a package substrate 1 by using an adhesive layer 06.

FIG. 25 is a schematic diagram of a structure of a bottom plate 11 in FIG. 24, and FIG. 26 is a schematic diagram of a structure of the cover plate 12 in FIG. 24. With reference to FIG. 24 and FIG. 25, a cavity 122 is formed in the cover plate 12. In the cavity 122, a shape matching the shape of the bottom plate 11 is formed by a sealing plate 123, and a spoiler 17 is disposed in a space formed by the sealing plate 123. The bottom plate 11 provided with a separator 15 is engaged with and fixed to the sealing plate 123 of the cover plate 12, to form the heat dissipating lid structure shown in FIG. 24.

In the heat dissipating lids 05 of different structures shown above, the separators 15 are formed on the bottom plate 11, and constitute an integrated structure with the bottom plate 11. For example, the separator 15 may be formed on the bottom plate 11 by using a skiving procedure. The following shows a specific process of forming the separator 15 by using the skiving procedure with reference to accompanying drawings.

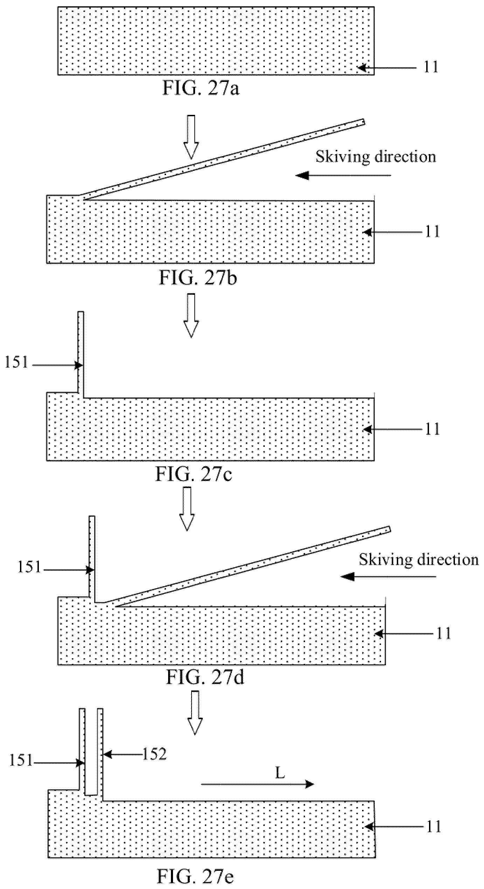

As shown in FIG. 27a, the bottom plate 11 is provided. The bottom plate 11 may be made of a copper material.

As shown in FIG. 27b, a part of the bottom plate 11 is skived from a surface of the bottom plate 11 along a skiving direction shown in the figure. It should be noted that the part skived here cannot be cut off from the bottom plate 11.

As shown in FIG. 27c, the part skived from the surface of the bottom plate 11 is upright, so that a first separator 151 integrated with the bottom plate 11 is obtained.

As shown in FIG. 27d, another part of the bottom plate 11 is continuously skived from the surface of the bottom plate 11 along a skiving direction shown in the figure. A procedure of this step is the same as the procedure shown in FIG. 27b.

As shown in FIG. 27e, the part skived from the surface of the bottom plate 11 is upright, so that a second separator 152 integrated with the bottom plate 11 is obtained.

If a plurality of separators need to be disposed, a plurality of separators integrated with the bottom plate 11 may be made in the skiving manner shown in FIG. 27a to FIG. 27e.

The separator 15 integrated with the bottom plate 11 is obtained based on the foregoing skiving method. It can be seen that, compared with an existing procedure of welding the separator 15 to the bottom plate 11 by using a welding procedure, the structure provided in this application can avoid a problem of large contact thermal resistance in an existing welding technology. Because when the separator 15 and the bottom plate 11 have large contact thermal resistance, a heat dissipation effect for the chip is reduced. Therefore, by using the separator prepared by the skiving procedure in this application and integrated with the bottom plate 11, the thermal resistance can be reduced, and the heat dissipation effect can be improved.

When a plurality of separators are formed by using the foregoing skiving procedure, with reference to FIG. 27e, the plurality of separators are arranged in a stepped structure along an L arrangement direction shown in FIG. 27e. For example, the first separator 151 and the second separator 152 in FIG. 27e are arranged in a stepped manner.

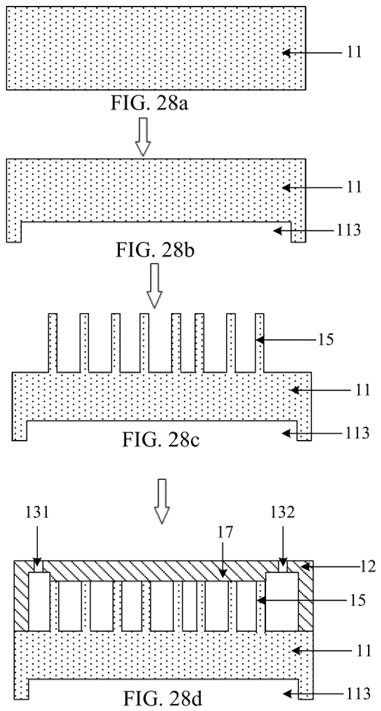

FIG. 28a to FIG. 28d are schematic diagrams of structures after each step of obtaining the heat dissipating lid structure including the spoiler 17 is completed.

As shown in FIG. 28a, the bottom plate 11 is provided. The bottom plate 11 may be made of a copper material.

As shown in FIG. 28b, a concave cavity 113 is provided on a side surface of the bottom plate 11, and the concave cavity 113 is configured to enclose a chip inside the concave cavity 113.

As shown in FIG. 28c, a plurality of separators 15 arranged at intervals are formed on another side surface of the bottom plate 11 opposite to the concave cavity 113 by using the skiving method shown in FIG. 27a to FIG. 27e.

As shown in FIG. 28d, the cover plate 12 engages the bottom plate 11 formed with the separator 15, and the cover plate 12 and the bottom plate 11 are fixed to each other by using a laser welding procedure.

The cover plate 12 has a spoiler 17 of an integrated structure with the cover plate 12, and before the cover plate 12 and the bottom plate 11 are fixed to each other, an inlet port 131 and an outlet port 132 may be disposed on the cover plate 12.

In the different heat dissipating lid 05 structures shown above, the bottom plate 11 may be a solid structure made of a metal material, that is, there is no cavity in the bottom plate 11. In this way, to improve the heat dissipation effect, an orthogonal projection on the chip and of an area in which the plurality of separators are located is located in an edge of the chip, or an orthogonal projection on the chip and of an area in which the plurality of separators are located coincides with an edge of the chip.

If the orthogonal projection on the chip and of the plurality of separators is located outside the edge of the chip, that is, when the plurality of separators occupy a large area, in a case in which a flow of a cooling medium flowing into an inlet port is fixed, a flow rate of a cooling medium in a flow channel between the plurality of separators occupying a large area is reduced. In this way, the heat dissipation effect for the chip is reduced. Therefore, the orthogonal projection on the chip and of the area in which the plurality of separators are located is located in the edge of the chip, or the orthogonal projection on the chip and of the area in which the plurality of separators are located coincides with the edge of the chip, thereby increasing the flow rate of the cooling medium and improving heat dissipation performance.

In addition, the following further provides several different bottom plate 11 structures. These bottom plate 11 structures all have a uniform temperature structure, and the uniform temperature structure can diffuse heat transferred to the bottom plate 11 as soon as possible. In this way, the heat dissipation performance can be further improved, and a chip hot spot can be eliminated as soon as possible.

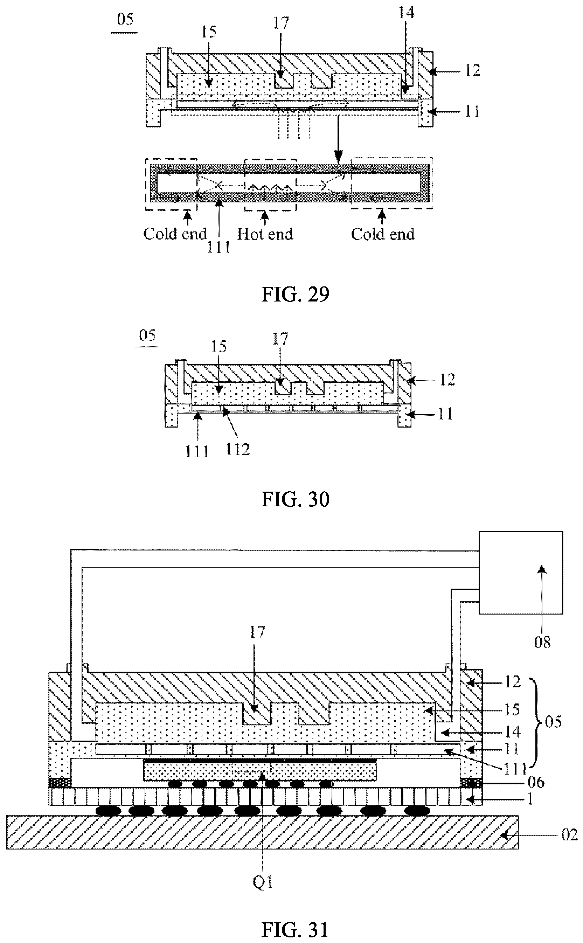

FIG. 29 shows a cross section view of another heat dissipating lid 05, which is the same as the heat dissipating lid 05 provided above, and includes a bottom plate 11 and a cover plate 12 that are engaging each other, and a separator 15 and a spoiler 17 that are disposed in a fluid cavity 14. A difference lies in that the bottom plate 11 in the heat dissipating lid 05 uses a vapor chamber (vapor chamber, VC) structure. As shown in an enlarged diagram of FIG. 29, a vapor chamber includes a wick 111 embedded in the bottom plate 11, the wick 111 has a coolant, a cavity in the wick is a vacuum cavity, and the wick 111 is formed by a capillary porous material. In the enlarged diagram in FIG. 29, a dashed line with an arrow is shown as steam, a solid line with an arrow is shown as liquid, and approximate locations of a cold end and a hot end are shown. For example, after heat of a chip hot spot is transferred to the wick 111 (the part of the wick may be referred to as a hot end), a coolant (for example, water) in the wick 111 absorbs heat and evaporates, and takes away the heat, and steam flows from the vacuum cavity to the cold end of the wick 111 and is condensed into liquid, and latent heat is released. Under the action of the capillary porous material, the liquid flows back to the hot end. In this way, a cycle is completed, and a large amount of heat is transferred from the hot end to the cold end.

Because a vacuum cavity is formed in the wick 111, a strength of the entire bottom plate 11 is affected, and the cover plate 12 disposed on the bottom plate 11 has a pressure effect on the bottom plate 11. To improve the strength of the bottom plate 11, as shown in FIG. 30, a support column 112 may be disposed in the vacuum cavity, to increase the strength of the entire bottom plate 11.

A structure shown in FIG. 31 includes a heat dissipating lid 05 configured to dissipate heat for a chip 2, and a bottom plate 11 of the heat dissipating lid 05 in the structure may be the bottom plate 11 structure shown in FIG. 29 or FIG. 30.

For example, in FIG. 31, the chip 2 has a hot spot Q1. After heat dissipated by the hot spot Q1 enters a wick 111, the heat diffuses in a direction parallel to the chip 2. In addition, with a joint action of a spoiler 17 disposed on the hot spot Q1, a temperature of the hot spot Q1 can be quickly reduced, and finally the hot spot Q1 can be eliminated.

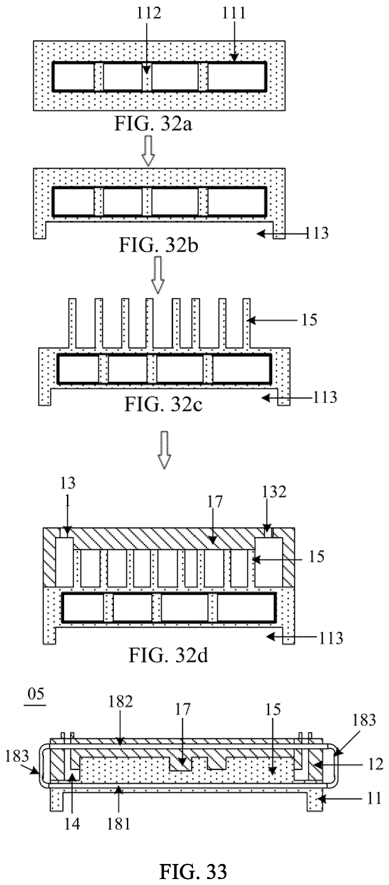

FIG. 32a to FIG. 32d are schematic diagrams of structures after each step of obtaining the heat dissipating lid structure in FIG. 30 is completed.

As shown in FIG. 32a, a vapor chamber (vapor chamber, VC) is provided. The vapor chamber may be made of a copper material.

As shown in FIG. 32b, a concave cavity 113 is provided on a side of the vapor chamber, and the concave cavity 113 is configured to enclose a chip inside the concave cavity 113.

As shown in FIG. 32c, a plurality of separators 15 arranged at intervals are formed on another side surface of the vapor chamber opposite to the concave cavity 113 by using the skiving method shown in FIG. 27a to FIG. 27e.

As shown in FIG. 32d, the cover plate 12 engages the vapor chamber formed with the separator 15, and the cover plate 12 and the vapor chamber are fixed to each other by using a laser welding procedure.

The cover plate 12 has a spoiler 17 of an integrated structure with the cover plate 12, and before the cover plate 12 and the vapor chamber are fixed to each other, an inlet port 131 and an outlet port 132 may be disposed on the cover plate 12.

FIG. 33 shows a cross section view of another heat dissipating lid 05, which is the same as the heat dissipating lid 05 provided above, and includes a bottom plate 11 and a cover plate 12 that engages each other, and a separator 15 and a spoiler 17 that are disposed in a fluid cavity 14. A difference lies in that a heat dissipation channel 181 is provided in the cover plate 12, a heat dissipation channel 182 is also provided in the bottom plate 11, and the heat dissipation channel 181 is communicated with the heat dissipation channel 182.

The heat dissipation channel 181 and the heat dissipation channel 182 may extend in a direction parallel to a chip. In this way, the heat dissipation channel 181 and the heat dissipation channel 182 may also achieve an effect of uniform temperature, and a hot spot of the chip can be quickly eliminated.

For example, in some optional implementations, with reference to FIG. 33, a heat pipe may be embedded in the cover plate 12, and a heat pipe may be embedded in the bottom plate 11. The heat pipe located in the cover plate 12 forms the heat dissipation channel 182, and the heat pipe located in the bottom plate 11 forms the heat dissipation channel 181. A structure of the heat pipe is basically the same as a structure of the vapor chamber, and the heat pipe also includes a wick. The wick has a coolant, a cavity in the wick is a vacuum cavity, and the wick is formed by a capillary porous material. A uniform temperature principle of the heat pipe is the same as a uniform temperature principle of the foregoing vapor chamber, and details are not described herein again.

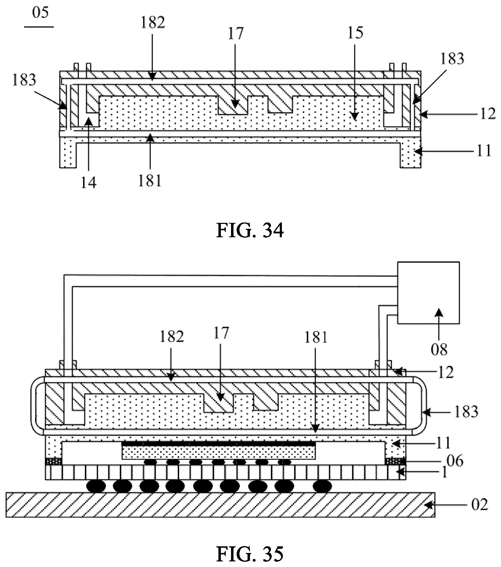

The heat dissipation channel 181 and the heat dissipation channel 182 may also be communicated in a plurality of manners. For example, in FIG. 33, the heat dissipation channel 181 and the heat dissipation channel 182 may be communicated by using a connection heat pipe 183 disposed outside the bottom plate 11 and the cover plate 12 that are engaged. For another example, in FIG. 34, the connection heat pipe 183 may be disposed in the cover plate 12 and the bottom plate 11 to communicate the heat dissipation channel 181 with the heat dissipation channel 182.

A structure shown in FIG. 35 includes a heat dissipating lid configured to dissipate heat for a chip 2, and similarly, also includes a package substrate 1, the chip 2 disposed on the package substrate 1, a PCB 02 carrying the package substrate 1, and the heat dissipating lid 05 covering the chip 2. The heat dissipating lid 05 herein may be the heat dissipating lid 05 shown in FIG. 33.

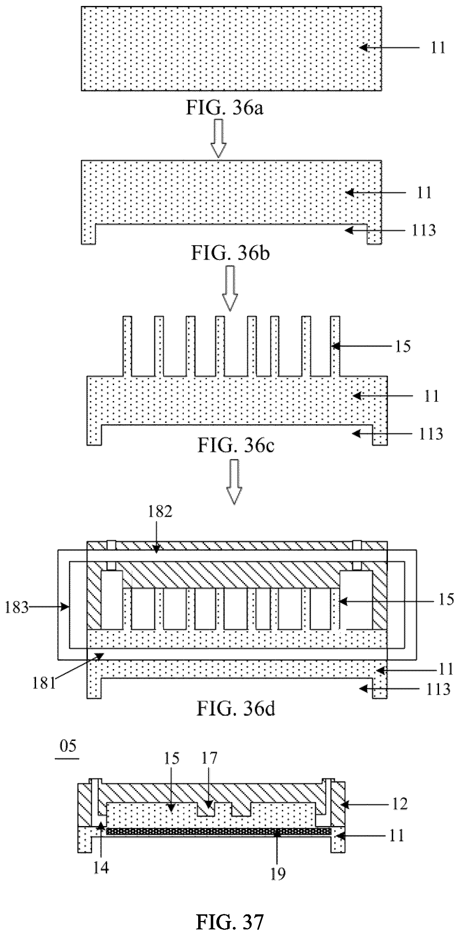

FIG. 36a to FIG. 36d are schematic diagrams of structures after each step of obtaining the heat dissipating lid structure in FIG. 33 is completed.

As shown in FIG. 36a, the bottom plate 11 is provided. The bottom plate 11 may be made of a copper material.

As shown in FIG. 36b, a concave cavity 113 is provided on a side surface of the bottom plate 11, and the concave cavity 113 is configured to enclose a chip inside the concave cavity 113.

As shown in FIG. 36c, similarly, a plurality of separators 15 arranged at intervals are formed on another side surface of the bottom plate 11 opposite to the concave cavity 113 by using the skiving method shown in FIG. 27a to FIG. 27e.

As shown in FIG. 36d, the cover plate 12 engages the bottom plate 11 formed with the separator 15, and the cover plate 12 and the bottom plate 11 are fixed to each other by using a welding procedure.

When steps shown in FIG. 36d are performed, before the cover plate 12 engages the bottom plate 11, the heat pipe may be embedded in the cover plate 12, and the heat pipe may be embedded in the bottom plate 11. After the cover plate 12 and the bottom plate 11 are engaged and fixedly connected to each other, the two heat pipes are communicated by using the connection heat pipe 183.

FIG. 37 shows a cross section view of another heat dissipating lid 05, which is the same as the heat dissipating lid 05 provided above, and includes a bottom plate 11 and a cover plate 12 that are engaged with and fixed to each other, a separator 15 disposed in a fluid cavity 14, and a spoiler 17 disposed between two adjacent separators 15. A difference lies in that the bottom plate 11 is filled with a filling structure 19, and a heat conductivity of the filling structure 19 is higher than that of the bottom plate 11. For example, when the bottom plate 11 is made of a copper material, a diamond sheet may be selected as the filling structure 19.

When the filling structure 19 with high heat conductivity is disposed in the bottom plate 11, heat diffusion efficiency can be improved by using the filling structure 19, and heat dissipated by a chip can be diffused as soon as possible. In addition, the filling structure 19 also has a uniform temperature effect, and a hot spot of the chip can be quickly eliminated.

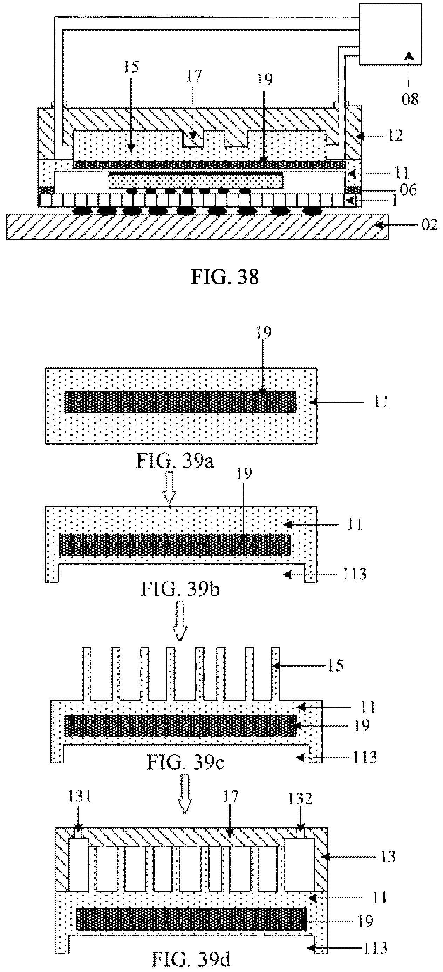

A structure shown in FIG. 38 includes a heat dissipating lid configured to dissipate heat for a chip 2, and similarly, also includes a package substrate 1, the chip 2 disposed on the package substrate 1, a PCB 02 carrying the package substrate 1, and the heat dissipating lid 05 covering the chip 2. The heat dissipating lid 05 herein may be the heat dissipating lid 05 shown in FIG. 37.

FIG. 39a to FIG. 39d are schematic diagrams of structures after each step of obtaining the heat dissipating lid structure in FIG. 37 is completed.

As shown in FIG. 39a, the bottom plate 11 is provided. The bottom plate 11 may be made of a copper material. In addition, a filling structure 19 with heat conductivity higher than that of the bottom plate 11 is embedded in the bottom plate 11, for example, a diamond sheet may be embedded in the bottom plate 11.

As shown in FIG. 39b, a concave cavity 113 is provided on a side surface of the bottom plate 11, and the concave cavity 113 is configured to enclose a chip inside the concave cavity 113.

As shown in FIG. 39c, similarly, a plurality of separators 15 arranged at intervals are formed on another side surface of the bottom plate 11 opposite to the concave cavity 113 by using the skiving method shown in FIG. 27a to FIG. 27e.

As shown in FIG. 39d, the cover plate 12 engages the bottom plate 11 formed with the separator 15, and the cover plate 12 and the bottom plate 11 are fixed to each other by using a welding procedure.

In addition, the cover plate 12 has a spoiler 17 in an integrated structure with the cover plate 12. Before the cover plate 12 and the bottom plate 11 are fixed to each other, an inlet port 131 and an outlet port 132 may be disposed on the cover plate 12.

In the foregoing heat dissipating lid structure with a uniform temperature structure, an orthogonal projection on the chip and of an area in which a plurality of separators are located on the chip may be located outside an edge of the chip, or an orthogonal projection on the chip and of an area in which a plurality of separators are located on the chip coincides with an edge of the chip, or an orthogonal projection on the chip and of an area in which a plurality of separators are located on the chip may be located in an edge of the chip.

The heat dissipating lid based on the foregoing different structures includes a spoiler that protrudes from the cover plate to a flow channel, and increases a local flow rate by using the spoiler, to improve a heat dissipation effect; or may include a uniform temperature structure disposed in the bottom plate, to improve a transverse (a direction parallel to the chip) heat diffusion speed of the bottom plate; or may be a separator structure that is integrated with the bottom plate by using a skiving procedure, to reduce contact thermal resistance and improve heat dissipation performance.

## Claims

1. A chip package structure (10), comprising:
a package substrate (1);
a chip (2), disposed on the package substrate (1); and
a heat dissipating lid (5), wherein the heat dissipating lid (5) covers a side of the chip (2) away from the package substrate (1); and
the heat dissipating lid (5) comprises:
a bottom plate (11);
a cover plate (12) engaging the bottom plate (11), wherein a fluid cavity (4, 14) is formed between the bottom plate (11) and the cover plate (12) that are engaged;
at least one separator (15), extending along the fluid cavity (4, 14), and dividing the fluid cavity (4, 14) into at least two flow channels (16); **characterised by**
at least one spoiler (17, 171, 172), protruding from the cover plate (12) to the at least two flow channels (16),
wherein the at least one spoiler (17, 171, 172) crosses the at least one separator (15).

2. The chip package structure (10) according to claim 1, wherein a slot (1511, 1521) is provided on a part of the at least one separator (15) close to the cover plate (12), and the at least one spoiler (17, 171, 172) is inserted into the slot (1511, 1521).

3. The chip package structure (10) according to claim 1 or 2, wherein there are a plurality of spoilers (17), and the plurality of spoilers (17) are arranged at intervals along an extension direction of the flow channel (16).

4. The chip package structure (10) according to any one of claims 1 to 3, wherein a spacing between a side surface of the spoiler (17, 171, 172) close to the bottom plate (11) and a bottom surface (161) of the flow channel (16) is D2, a depth of the flow channel (16) along an engaging direction of the bottom plate (11) and the cover plate (12) is D1, and $\frac{D 2}{D 1} \leq 50 %$.

5. The chip package structure (10) according to any one of claims 1 to 4, wherein the spoiler (17, 171, 172) and the cover plate (12) constitute an integrated structure.

6. The chip package structure (10) according to any one of claims 1 to 5, wherein there are a plurality of separators, the plurality of separators are arranged in the fluid cavity (4, 14) at intervals, the plurality of separators and the bottom plate (11) constitute an integrated structure, and the plurality of separators are arranged in a stepped manner along an arrangement direction thereof.

7. The chip package structure (10) according to any one of claims 1 to 6, wherein a uniform temperature structure is disposed in the bottom plate (11), and the uniform temperature structure extends in a direction parallel to the chip (2).

8. The chip package structure (10) according to claim 7, wherein the uniform temperature structure comprises a wick (111) embedded in the bottom plate (11), the wick (111) has a coolant, and a cavity in the wick (111) is a vacuum cavity.

9. The chip package structure (10) according to claim 7 or 8, wherein the uniform temperature structure comprises a first heat pipe embedded in the bottom plate (11); and
the heat dissipating lid (5) further comprises:
a second heat pipe, wherein the second heat pipe is embedded in the cover plate (12), and the second heat pipe is communicated with the first heat pipe.

10. The chip package structure (10) according to any one of claims 7 to 9, wherein the uniform temperature structure comprises a filling structure (19) embedded in the bottom plate (11), and a heat conductivity of the filling structure (19) is greater than a heat conductivity of the bottom plate (11).

11. The chip package structure (10) according to claim 10, wherein the filling structure (19) comprises a diamond sheet.

12. The chip package structure (10) according to any one of claims 1 to 11, wherein at least one drainage plate is disposed in the fluid cavity (4, 14), and the at least one drainage plate protrudes from the cover plate (12) to a port (63, 64, 81, 82, 131-133) of the flow channel (16).

13. The chip package structure (10) according to any one of claims 1 to 12, wherein the fluid cavity (4, 14) comprises a first area, and a second area located on one side of the first area, and the at least one separator (15) is located in the first area;
a size of the second area in a first direction along a direction approaching the first area gradually increases; and
the first direction is a direction perpendicular to an arrangement direction of the first area and the second area.

14. The chip package structure (10) according to any one of claims 1 to 13, wherein an orthogonal projection on the chip (2) and of an area in which the at least one separator (15) is located is located in an edge of the chip (2); or
an orthogonal projection on the chip (2) and of an area in which the at least one separator (15) is located coincides with an edge of the chip (2).

15. The chip package structure (10) according to any one of claims 1 to 14, wherein a concave cavity (113) is formed on a side surface of the bottom plate (11) facing the chip (2), the chip (2) is enclosed in the concave cavity (113), and the bottom plate (11) is connected to the package substrate (1) by using an adhesive layer (6).

16. The chip package structure (10) according to any one of claims 1 to 14, wherein a concave cavity (113) is formed on a side surface of the cover plate (12) facing the chip (2), the bottom plate (11) and the chip (2) are both enclosed in the concave cavity (113), and the cover plate (12) is connected to the package substrate (1) by using an adhesive layer (6).

## Patentansprüche

1. Chipgehäusestruktur (10), umfassend:
ein Gehäusesubstrat (1);
einen Chip (2), der auf dem Gehäusesubstrat (1) angeordnet ist; und
einen Wärmeableitungsdeckel (5), wobei der Wärmeableitungsdeckel (5) eine Seite des Chips (2) abdeckt, die von dem Gehäusesubstrat (1) abgewandt ist; und
der Wärmeableitungsdeckel (5) Folgendes umfasst:
eine Bodenplatte (11);
eine Deckplatte (12), die mit der Bodenplatte (11) in Eingriff steht, wobei ein Fluidhohlraum (4, 14) zwischen der Bodenplatte (11) und der Deckplatte (12), die in Eingriff stehen, ausgebildet ist;
mindestens einen Separator (15), der sich entlang des Fluidhohlraums (4, 14) erstreckt und den Fluidhohlraum (4, 14) in mindestens zwei Strömungskanäle (16) unterteilt; **gekennzeichnet durch**
mindestens einen Spoiler (17, 171, 172), der von der Deckplatte (12) zu den mindestens zwei Strömungskanälen (16) vorsteht,
wobei der mindestens eine Spoiler (17, 171, 172) den mindestens einen Separator (15) kreuzt.

2. Chipgehäusestruktur (10) nach Anspruch 1, wobei ein Schlitz (1511, 1521) an einem Teil des mindestens einen Separators (15) nahe der Deckplatte (12) vorgesehen ist, und der mindestens eine Spoiler (17, 171, 172) in den Schlitz (1511, 1521) eingeführt ist.

3. Chipgehäusestruktur (10) nach Anspruch 1 oder 2, wobei eine Vielzahl von Spoilern (17) vorhanden ist, und die Vielzahl von Spoilern (17) in Abständen entlang einer Erstreckungsrichtung des Strömungskanals (16) angeordnet ist.

4. Chipgehäusestruktur (10) nach einem der Ansprüche 1 bis 3, wobei ein Abstand zwischen einer Seitenfläche des Spoilers (17, 171, 172) nahe der Bodenplatte (11) und einer Bodenfläche (161) des Strömungskanals (16) D2 ist, eine Tiefe des Strömungskanals (16) entlang einer Eingriffsrichtung der Bodenplatte (11) und der Deckplatte (12) D1 ist, und $\frac{D 2}{D 1} \leq 50 %$.

5. Chipgehäusestruktur (10) nach einem der Ansprüche 1 bis 4, wobei der Spoiler (17, 171, 172) und die Deckplatte (12) eine integrierte Struktur bilden.

6. Chipgehäusestruktur (10) nach einem der Ansprüche 1 bis 5, wobei eine Vielzahl von Separatoren vorhanden ist, die Vielzahl von Separatoren in dem Fluidhohlraum (4, 14) in Abständen angeordnet ist, die Vielzahl von Separatoren und die Bodenplatte (11) eine integrierte Struktur bilden, und die Vielzahl von Separatoren stufenförmig entlang einer Anordnungsrichtung davon angeordnet ist.

7. Chipgehäusestruktur (10) nach einem der Ansprüche 1 bis 6, wobei eine Struktur für gleichmäßige Temperatur in der Bodenplatte (11) angeordnet ist, und die Struktur für gleichmäßige Temperatur sich in einer Richtung parallel zu dem Chip (2) erstreckt.

8. Chipgehäusestruktur (10) nach Anspruch 7, wobei die Struktur für gleichmäßige Temperatur einen Docht (111) umfasst, der in die Bodenplatte (11) eingebettet ist, der Docht (111) ein Kühlmittel aufweist, und ein Hohlraum in dem Docht (111) ein Vakuumhohlraum ist.

9. Chipgehäusestruktur (10) nach Anspruch 7 oder 8, wobei die Struktur für gleichmäßige Temperatur ein erstes Wärmerohr umfasst, das in die Bodenplatte (11) eingebettet ist; und
der Wärmeableitungsdeckel (5) ferner Folgendes umfasst:
ein zweites Wärmerohr, wobei das zweite Wärmerohr in die Deckplatte (12) eingebettet ist, und das zweite Wärmerohr mit dem ersten Wärmerohr in Verbindung steht.

10. Chipgehäusestruktur (10) nach einem der Ansprüche 7 bis 9, wobei die Struktur für gleichmäßige Temperatur eine Füllstruktur (19) umfasst, die in die Bodenplatte (11) eingebettet ist, und eine Wärmeleitfähigkeit der Füllstruktur (19) größer als eine Wärmeleitfähigkeit der Bodenplatte (11) ist.

11. Chipgehäusestruktur (10) nach Anspruch 10, wobei die Füllstruktur (19) eine Diamantplatte umfasst.

12. Chipgehäusestruktur (10) nach einem der Ansprüche 1 bis 11, wobei mindestens eine Ablaufplatte in dem Fluidhohlraum (4, 14) angeordnet ist, und die mindestens eine Ablaufplatte von der Deckplatte (12) zu einem Anschluss (63, 64, 81, 82, 131-133) des Strömungskanals (16) vorsteht.

13. Chipgehäusestruktur (10) nach einem der Ansprüche 1 bis 12, wobei der Fluidhohlraum (4, 14) einen ersten Bereich und einen zweiten Bereich, der auf einer Seite des ersten Bereichs angeordnet ist, umfasst, und der mindestens eine Separator (15) in dem ersten Bereich angeordnet ist;
eine Größe des zweiten Bereichs in einer ersten Richtung entlang einer Richtung, die sich dem ersten Bereich nähert, allmählich zunimmt; und
die erste Richtung eine Richtung senkrecht zu einer Anordnungsrichtung des ersten Bereichs und des zweiten Bereichs ist.

14. Chipgehäusestruktur (10) nach einem der Ansprüche 1 bis 13, wobei eine orthogonale Projektion auf den Chip (2) und eines Bereichs, in dem der mindestens eine Separator (15) angeordnet ist, in einem Rand des Chips (2) angeordnet ist; oder
eine orthogonale Projektion auf den Chip (2) und eines Bereichs, in dem der mindestens eine Separator (15) angeordnet ist, mit einem Rand des Chips (2) zusammenfällt.

15. Chipgehäusestruktur (10) nach einem der Ansprüche 1 bis 14, wobei ein konkaver Hohlraum (113) an einer Seitenfläche der Bodenplatte (11), die dem Chip (2) zugewandt ist, ausgebildet ist, der Chip (2) in dem konkaven Hohlraum (113) eingeschlossen ist, und die Bodenplatte (11) durch Verwenden einer Klebeschicht (6) mit dem Gehäusesubstrat (1) verbunden ist.

16. Chipgehäusestruktur (10) nach einem der Ansprüche 1 bis 14, wobei ein konkaver Hohlraum (113) an einer Seitenfläche der Deckplatte (12), die dem Chip (2) zugewandt ist, ausgebildet ist, die Bodenplatte (11) und der Chip (2) beide in dem konkaven Hohlraum (113) eingeschlossen sind, und die Deckplatte (12) durch Verwenden einer Klebeschicht (6) mit dem Gehäusesubstrat (1) verbunden ist.

## Revendications

1. Structure d'encapsulation de puce (10), comprenant :
un substrat d'encapsulation (1) ;
une puce (2), disposée sur le substrat d'encapsulation (1) ; et
un couvercle dissipateur de chaleur (5), dans laquelle le couvercle dissipateur de chaleur (5) recouvre une face de la puce (2) opposée au substrat d'encapsulation (1) ; et
le couvercle dissipateur de chaleur (5) comprend :
une plaque inférieure (11) ;
une plaque de recouvrement (12) venant en prise avec la plaque inférieure (11), dans laquelle une cavité de fluide (4, 14) est formée entre la plaque inférieure (11) et la plaque de recouvrement (12) qui sont en prise ;
au moins un séparateur (15), s'étendant le long de la cavité de fluide (4, 14) et divisant la cavité de fluide (4, 14) en au moins deux canaux d'écoulement (16) ; **caractérisée par**
au moins un déflecteur (17, 171, 172), faisant saillie de la plaque de recouvrement (12) vers les au moins deux canaux d'écoulement (16),
dans laquelle l'au moins un déflecteur (17, 171, 172) traverse au moins un séparateur (15).

2. Structure d'encapsulation de puce (10) selon la revendication 1, dans laquelle une fente (1511, 1521) est prévue sur une partie de l'au moins un séparateur (15) proche de la plaque de recouvrement (12), et l'au moins un déflecteur (17, 171, 172) est inséré dans la fente (1511, 1521).

3. Structure d'encapsulation de puce (10) selon la revendication 1 ou 2, dans laquelle il existe une pluralité de déflecteurs (17), et la pluralité de déflecteurs (17) sont disposés à intervalles réguliers le long d'une direction d'extension du canal d'écoulement (16).

4. Structure d'encapsulation de puce (10) selon l'une quelconque des revendications 1 à 3, dans laquelle un espacement entre une surface latérale du déflecteur (17, 171, 172) proche de la plaque inférieure (11) et une surface inférieure (161) du canal d'écoulement (16) est D2, la profondeur du canal d'écoulement (16) le long d'une direction de prise de la plaque inférieure (11) et de la plaque de recouvrement (12) est D1, et $\frac{D 2}{D 1} \leq 50 %$.

5. Structure d'encapsulation de puce (10) selon l'une quelconque des revendications 1 à 4, dans laquelle le déflecteur (17, 171, 172) et la plaque de recouvrement (12) constituent une structure intégrée.

6. Structure d'encapsulation de puce (10) selon l'une quelconque des revendications 1 à 5, dans laquelle il existe une pluralité de séparateurs, la pluralité de séparateurs sont disposés à intervalles réguliers dans la cavité de fluide (4, 14), la pluralité de séparateurs et la plaque inférieure (11) constituent une structure intégrée, et la pluralité de séparateurs sont disposés de manière étagée le long d'une direction d'agencement de ceux-ci.

7. Structure d'encapsulation de puce (10) selon l'une quelconque des revendications 1 à 6, dans laquelle une structure à température uniforme est disposée dans la plaque inférieure (11), et la structure à température uniforme s'étend dans une direction parallèle à la puce (2).

8. Structure d'encapsulation de puce (10) selon la revendication 7, dans laquelle la structure à température uniforme comprend une mèche (111) intégrée dans la plaque inférieure (11), la mèche (111) contient un liquide de refroidissement et une cavité dans la mèche (111) est une cavité sous vide.

9. Structure d'encapsulation de puce (10) selon la revendication 7 ou 8, dans laquelle la structure à température uniforme comprend un premier caloduc intégré dans la plaque inférieure (11) ; et
le couvercle dissipateur de chaleur (5) comprend en outre :
un second caloduc, dans laquelle le second caloduc est intégré dans la plaque de recouvrement (12), et le second caloduc communique avec le premier caloduc.

10. Structure d'encapsulation de puce (10) selon l'une quelconque des revendications 7 à 9, dans laquelle la structure à température uniforme comprend une structure de remplissage (19) intégrée dans la plaque inférieure (11), et une conductivité thermique de la structure de remplissage (19) est supérieure à la conductivité thermique de la plaque inférieure (11).

11. Structure d'encapsulation de puce (10) selon la revendication 10, dans laquelle la structure de remplissage (19) comprend une feuille de diamant.

12. Structure d'encapsulation de puce (10) selon l'une quelconque des revendications 1 à 11, dans laquelle au moins une plaque de drainage est disposée dans la cavité de fluide (4, 14), et l'au moins une plaque de drainage fait saillie de la plaque de recouvrement (12) vers un orifice (63, 64, 81, 82, 131-133) du canal d'écoulement (16).

13. Structure d'encapsulation de puce (10) selon l'une quelconque des revendications 1 à 12, dans laquelle la cavité de fluide (4, 14) comprend une première zone et une seconde zone située d'un côté de la première zone, et l'au moins un séparateur (15) est situé dans la première zone ;
la taille de la seconde zone dans une première direction, le long d'une direction s'approchant de la première zone, augmente progressivement ; et
la première direction est une direction perpendiculaire à la direction d'agencement de la première zone et de la seconde zone.

14. Structure d'encapsulation de puce (10) selon l'une quelconque des revendications 1 à 13, dans laquelle une projection orthogonale sur la puce (2) et d'une zone dans laquelle se trouve l'au moins un séparateur (15) est située sur un bord de la puce (2) ; ou
une projection orthogonale sur la puce (2) et d'une zone dans laquelle se trouve l'au moins un séparateur (15) coïncide avec un bord de la puce (2).

15. Structure d'encapsulation de puce (10) selon l'une quelconque des revendications 1 à 14, dans laquelle une cavité concave (113) est formée sur une surface latérale de la plaque inférieure (11) faisant face à la puce (2), la puce (2) est enfermée dans la cavité concave (113), et la plaque inférieure (11) est reliée au substrat d'encapsulation (1) à l'aide d'une couche adhésive (6).

16. Structure d'encapsulation de puce (10) selon l'une quelconque des revendications 1 à 14, dans laquelle une cavité concave (113) est formée sur une surface latérale de la plaque ide recouvrement (12) faisant face à la puce (2), la plaque inférieure (11) et la puce (2) sont enfermées dans la cavité concave (113), et la plaque de recouvrement (12) est reliée au substrat d'encapsulation (1) à l'aide d'une couche adhésive (6).
